# EUROPEAN PATENT APPLICATION

(11) **EP 4 362 065 A1**
(43) Date of publication of application: **01.05.2024**
(21) Application number: 23189456.9
(22) Date of filing: 03.08.2023
(51) Int. Cl.: H01L 21/02, H01L 21/306, H01L 21/78

(54) **MANUFACTURING METHOD OF SEMICONDUCTOR ELEMENT, SEMICONDUCTOR LAYER SUPPORT STRUCTURE, AND SEMICONDUCTOR SUBSTRATE**

(30) Priority: 28.10.2022 JP 2022173115
(71) Applicant: Oki Electric Industry Co., Ltd., Minato-ku Tokyo 105-8460 (JP)
(72) Inventor: JUMONJI, Shinya, Tokyo, 105-8460 (JP); KOSAKA, Toru, Tokyo, 105-8460 (JP); SUZUKI, Takahito, Tokyo, 105-8460 (JP); TANIGAWA, Kenichi, Tokyo, 105-8460 (JP); NAKAI, Yusuke, Tokyo, 105-8460 (JP); KAWADA, Hiroto, Tokyo, 105-8460 (JP); MATSUO, Genichirou, Tokyo, 105-8460 (JP); KITAJIMA, Yutaka, Tokyo, 105-8460 (JP)
(74) Representative: Betten & Resch

(57) **Abstract**

A manufacturing method of a semiconductor element includes a formation process of forming a plurality of islands, each including a semiconductor layer (12) containing a nitride semiconductor and a support (13) formed on the semiconductor layer (12), on a sapphire substrate (11), a joining process of joining the support (13) to a retention substrate (15) via an adhesive member (14), a peeling process of peeling off the semiconductor layer (12) from the sapphire substrate (11) by irradiating the semiconductor layer (12) with laser light, and a polishing process of polishing a surface (12s) of the semiconductor layers (12) peeled off from the sapphire substrate (11) .

## Description

### BACKGROUND OF THE INVENTION

### 1. Field of the Invention

The present disclosure relates to a manufacturing method of a semiconductor element, a semiconductor layer support structure and a semiconductor substrate.

### 2. Description of the Related Art

Conventionally, there has been known a technology of flattening a surface of a semiconductor layer by means of polishing (see Patent Reference 1, for example).
Patent Reference 1: Japanese Patent Application Publication No. 2006-86388 (see ABSTRACT)

### SUMMARY OF THE INVENTION

In recent years, with the improvement of the flatness of the surface of the semiconductor layer, the load (stress or the like) acting on the semiconductor layer at the time of the polishing has the tendency to increase. Therefore, it is requested to reduce the load acting on the semiconductor layer at the time of the polishing.

The object of the present disclosure is to reduce the load acting on the semiconductor layer at the time of the polishing.

### SUMMARY OF THE INVENTION

A manufacturing method of a semiconductor element in the present disclosure includes a formation process of forming a plurality of islands, each including a semiconductor layer containing a nitride semiconductor and a support formed on the semiconductor layer, on a sapphire substrate, a joining process of joining the support to a retention substrate via an adhesive member, a peeling process of peeling off the semiconductor layer from the sapphire substrate by irradiating the semiconductor layer with laser light, and a polishing process of polishing a surface of the semiconductor layer peeled off from the sapphire substrate.

According to the present disclosure, the surface of the semiconductor layer is polished in a state in which the semiconductor layer is supported by the support, and thus the load acting on the semiconductor layer at the time of the polishing can be reduced.

### BRIEF DESCRIPTION OF THE DRAWINGS

FIG. 1 is a flowchart showing a manufacturing method of a semiconductor element in a first embodiment.
FIGS. 2(A) and 2(B) are a perspective view and a cross-sectional view schematically showing a state in which a semiconductor thin-film layer has been formed on a sapphire substrate in the manufacturing method of the semiconductor element in the first embodiment.
FIG. 3 is a plan view schematically showing semiconductor layers separated on the sapphire substrate in the manufacturing method of the semiconductor element in the first embodiment.
FIGS. 4(A), 4(B) and 4(C) are cross-sectional views schematically showing a process of singulating the semiconductor thin-film layer, a process of forming a support layer and a process of singulating the support layer in the manufacturing method of the semiconductor element in the first embodiment.
FIG. 5 is a cross-sectional view schematically showing a state in which supports have been joined to a retention substrate via an adhesive member in the manufacturing method of the semiconductor element in the first embodiment.
FIGS. 6(A) and 6(B) are cross-sectional views schematically showing configuration examples of the adhesive member in FIG. 5.
FIGS. 7(A), 7(B) and 7(C) are cross-sectional views schematically showing a process of peeling off the semiconductor layers from the sapphire substrate in the manufacturing method of the semiconductor element in the first embodiment.
FIGS. 8(A) and 8(B) are a cross-sectional view and a perspective view schematically showing a process of polishing the semiconductor layers in the manufacturing method of the semiconductor element in the first embodiment.
FIG. 9 is a cross-sectional view schematically showing a semiconductor layer support structure after the polishing of the semiconductor layers in the manufacturing method of the semiconductor element in the first embodiment.
FIGS. 10(A), 10(B) and 10(C) are cross-sectional views schematically showing a process of joining the semiconductor layers to a silicon substrate, a process of removing the adhesive member and a process of removing the supports in the manufacturing method of the semiconductor element in the first embodiment.
FIG. 11 is a diagram schematically showing the flow of slurry in the polishing process in the first embodiment.
FIGS. 12(A) to 12(D) are diagrams schematically showing a polishing state of semiconductor layers in a comparative example and a polishing state of the semiconductor layers in the first embodiment.
FIG. 13 is a flowchart showing a manufacturing method of a semiconductor element in a second embodiment.
FIGS. 14(A) to 14(E) are cross-sectional views schematically showing a process of singulating the semiconductor thin-film layer, a process of forming a first support layer, a process of singulating the first support layer, a process of forming a second support layer, and a process of singulating the second support layer in the manufacturing method of the semiconductor element in the second embodiment.
FIGS. 15(A), 15(B) and 15(C) are cross-sectional views schematically showing a process of peeling off semiconductor layers from a sapphire substrate in the manufacturing method of the semiconductor element in the second embodiment.
FIGS. 16(A) and 16(B) are a cross-sectional view and a perspective view schematically showing a process of polishing the semiconductor layers in the manufacturing method of the semiconductor element in the second embodiment.
FIG. 17 is a cross-sectional view schematically showing a semiconductor layer support structure after the polishing of the semiconductor layers in the manufacturing method of the semiconductor element in the second embodiment.
FIGS. 18(A), 18(B), 18(C) and 18(D) are cross-sectional views schematically showing a process of joining the semiconductor layers to the silicon substrate, a process of removing the adhesive member, a process of removing second supports and a process of removing first supports in the manufacturing method of the semiconductor element in the second embodiment.
FIG. 19 is a plan view showing semiconductor layers separated on a sapphire substrate in a manufacturing method of a semiconductor element in a third embodiment.
FIG. 20 is a plan view showing supports on the semiconductor layers in the manufacturing method of the semiconductor element in the third embodiment.
FIGS. 21(A), 21(B) and 21(C) are cross-sectional views schematically showing a process of singulating the semiconductor thin-film layer, a process of forming a support layer and a process of singulating the support layer in the manufacturing method of the semiconductor element in the third embodiment.
FIG. 22 is a cross-sectional view at a cross section different from FIG. 21(C) schematically showing the process of singulating the support layer in the manufacturing method of the semiconductor element in the third embodiment.
FIGS. 23(A) and 23(B) are a cross-sectional view and a perspective view schematically showing a process of polishing the semiconductor layers in the manufacturing method of the semiconductor element in the third embodiment.
FIG. 24 is a flowchart showing a manufacturing method of a semiconductor element in a fourth embodiment.
FIGS. 25(A) and 25(B) are a plan view schematically showing semiconductor layers separated on a sapphire substrate in the manufacturing method of the semiconductor element in the fourth embodiment and a plan view magnifying one semiconductor layer.
FIGS. 26(A) to 26(D) are cross-sectional views schematically showing a process of singulating a semiconductor thin-film layer, a process of forming grooves in semiconductor layers, a process of forming a support layer and a process of singulating the support layer in the manufacturing method of the semiconductor element in the fourth embodiment.
FIG. 27 is a cross-sectional view schematically showing a state in which supports have been joined to the retention substrate via the adhesive member in the manufacturing method of the semiconductor element in the fourth embodiment.
FIGS. 28(A) and 28(B) are diagrams showing examples of an island including the semiconductor layer and the support in the manufacturing method of the semiconductor element in the fourth embodiment.
FIGS. 29(A), 29(B) and 29(C) are cross-sectional views schematically showing a process of peeling off the semiconductor layers from the sapphire substrate in the manufacturing method of the semiconductor element in the fourth embodiment.
FIGS. 30(A) and 30(B) are a cross-sectional view and a perspective view schematically showing a process of polishing the semiconductor layers in the manufacturing method of the semiconductor element in the fourth embodiment.
FIG. 31 is a cross-sectional view schematically showing a support structure after the polishing of the semiconductor layers in the manufacturing method of the semiconductor element in the fourth embodiment.
FIGS. 32(A), 32(B) and 32(C) are cross-sectional views schematically showing a process of joining the semiconductor layers to the silicon substrate, a process of removing the adhesive member and a process of removing the supports in the manufacturing method of the semiconductor element in the fourth embodiment.

### DETAILED DESCRIPTION OF THE INVENTION

A manufacturing method of a semiconductor element according to each embodiment and a semiconductor layer support structure used for the manufacture of the semiconductor element will be described below with reference to the drawings. The following embodiments are just examples and a variety of modifications are possible within the scope of the present disclosure.

### (First Embodiment)

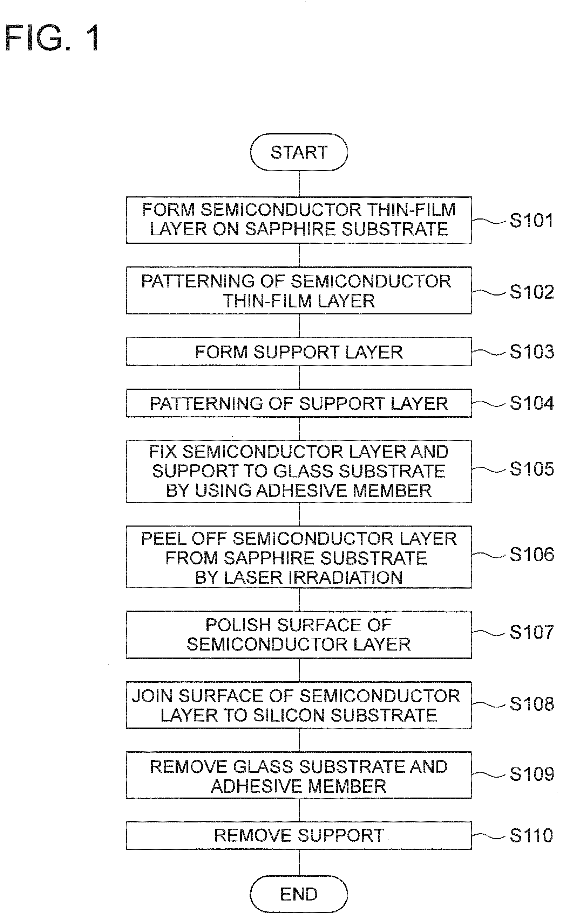

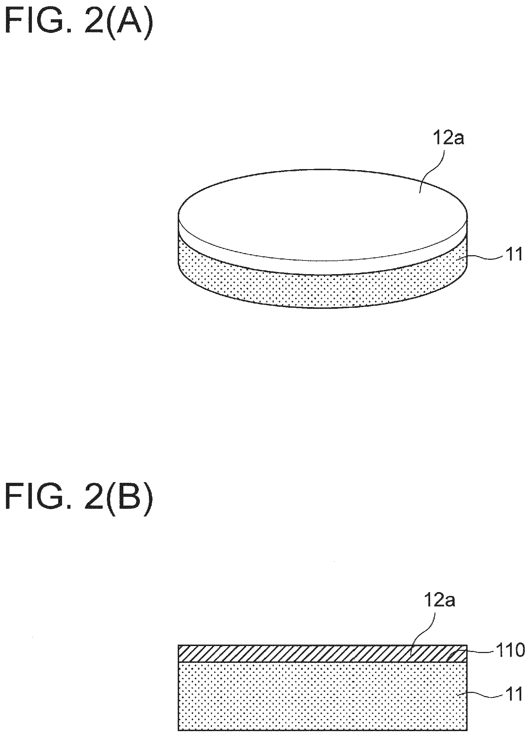

FIG. 1 is a flowchart showing a manufacturing method of a semiconductor element in a first embodiment. In step S101 shown in FIG. 1, a semiconductor thin-film layer 12a is formed on a sapphire substrate 11 as a growth substrate. FIGS. 2(A) and 2(B) are a perspective view and a cross-sectional view schematically showing a state in which the semiconductor thin-film layer 12a has been formed on the sapphire substrate 11.

### <Process of Forming Semiconductor Thin-film Layer>

The sapphire substrate 11 is a growth substrate on whose surface the semiconductor thin-film layer 12a is grown epitaxially, and is a wafer in a circular shape in this example. Incidentally, it is also possible to use a growth substrate other than a sapphire substrate as long as the semiconductor thin-film layer 12a can be grown epitaxially on the substrate.

The semiconductor thin-film layer 12a is a layer made of a nitride semiconductor, more specifically, a layer made of GaN (gallium nitride). The semiconductor thin-film layer 12a can be formed by epitaxially growing a monocrystalline GaN layer on the sapphire substrate 11. Incidentally, the semiconductor thin-film layer 12a is not limited to a layer made of a nitride semiconductor but may further contain a semiconductor other than a nitride semiconductor.

For use as an LED (Light-Emitting Diode), the semiconductor thin-film layer 12a may be formed of a stacked body obtained by stacking a buffer layer, an n-type GaN layer, an n-type AlGaN layer, an InGaN layer, a p-type AlGaN layer and a p-type GaN layer, for example.

### <Process of Singulating Semiconductor Thin-film Layer>

In the subsequent step S102 (FIG. 1), the semiconductor thin-film layer 12a on the sapphire substrate 11 is patterned by means of photolithography and thereby separated (singulated) into a plurality of semiconductor layers 12. Incidentally, the semiconductor layer 12 is referred to also as a semiconductor thin film (or a semiconductor thin film piece).

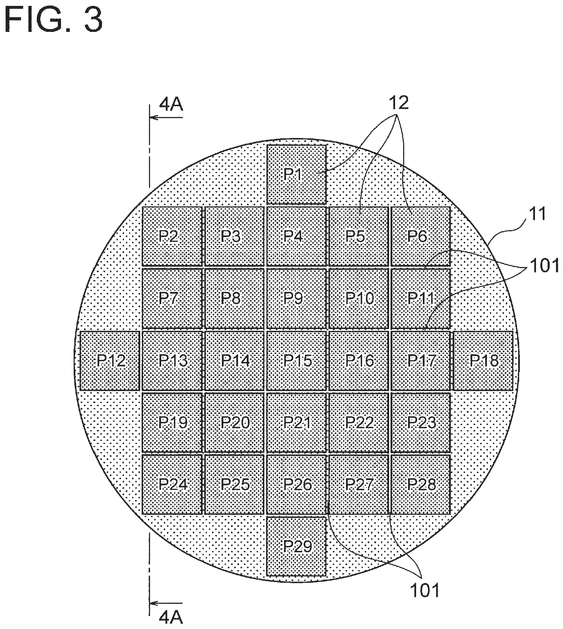

FIG. 3 is a plan view showing the semiconductor layers 12 after the separation. The semiconductor layers 12 are separated in a grid pattern by grooves 101 extending in two directions orthogonal to each other. The semiconductor layer 12 is in a square shape with each side 1 mm to 10 mm long, for example. However, the shape of the semiconductor layer 12 is not limited to the square shape but can also be a rectangular shape or a different shape.

In the example shown in FIG. 3, twenty-nine semiconductor layers 12 are arrayed on the sapphire substrate 11 to form chip parts (individual parts) P1 to P29. Among these chip parts, twenty-five chip parts P2 to P11, P13 to P17 and P19 to P28 are formed in five rows and five columns. Further, chip parts P1, P12, P18 and P29 are formed respectively on an outer peripheral side of the center (chip part P4) of the first row, the center (chip part P13) of the first column, the center (chip part P17) of the fifth column and the center (chip part P26) of the fifth row. However, the number and arrangement of the chip parts are not limited to this example.

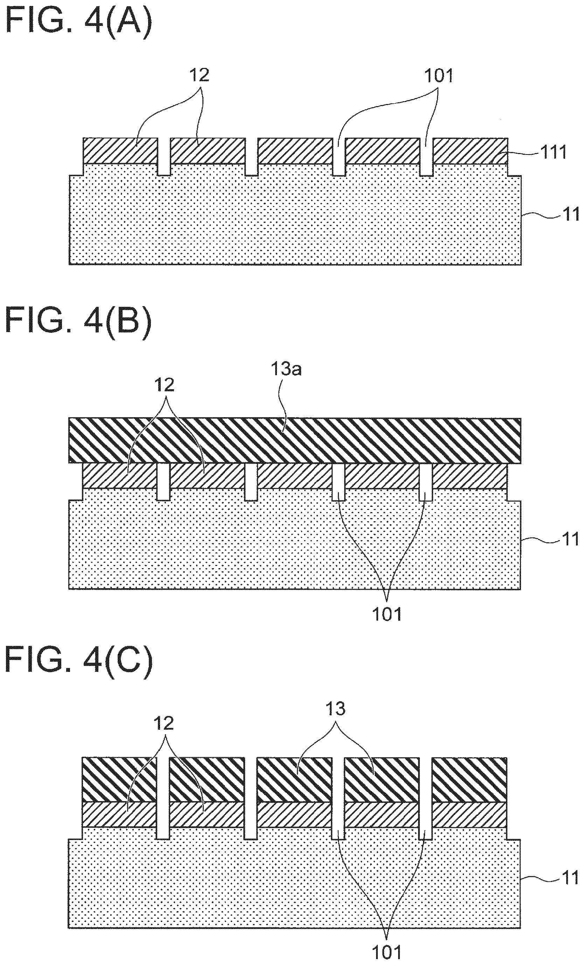

FIGS. 4(A), 4(B) and 4(C) are cross-sectional views schematically showing the process of singulating the semiconductor thin-film layer 12a on the sapphire substrate 11, a process of forming a support layer 13a and a process of singulating the support layer 13a. FIGS. 4(A) to 4(C) correspond to cross-sectional views taken along the line 4A - 4A shown in FIG. 3.

### <Process of Forming Support Layer>

In step S103 (FIG. 1), as shown in FIG. 4(B), the support layer 13a is formed to cover the semiconductor layers 12 separated on the sapphire substrate 11. The support layer 13a is formed of a resin. More specifically, the support layer 13a is formed of a negative-type photoresist based on "EPON_SU-8" being an epoxy resin.

### <Process of Singulating Support Layer>

In the subsequent step S104 (FIG. 1), as shown in FIG. 4(C), the support layer 13a is patterned by means of photolithography and thereby separated (singulated) into a plurality of supports 13 similarly to the semiconductor layers 12. Namely, the supports 13 are separated from each other by the grooves 101 similarly to the semiconductor layers 12.

By this process, a plurality of islands (stacked structures), each formed by stacking the semiconductor layer 12 and the support 13, are formed on the sapphire substrate 11.

The thickness of the semiconductor layer 12 is in a range of 1 µm to 10 µm, for example. On the other hand, the thickness of the support 13 is greater than (preferably, twice or more of) the thickness of the semiconductor layer 12, and is in a range of 10 µm to 100 µm, for example.

Further, the Young's modulus of the semiconductor layer 12 is 200 GPa, for example. On the other hand, the Young's modulus of the support 13 is lower than the Young's modulus of the semiconductor layer 12, and is 2.7 GPa, for example. In other words, the support 13 is softer and more likely to deform than the semiconductor layer 12.

### <Process of Joining to Glass Substrate>

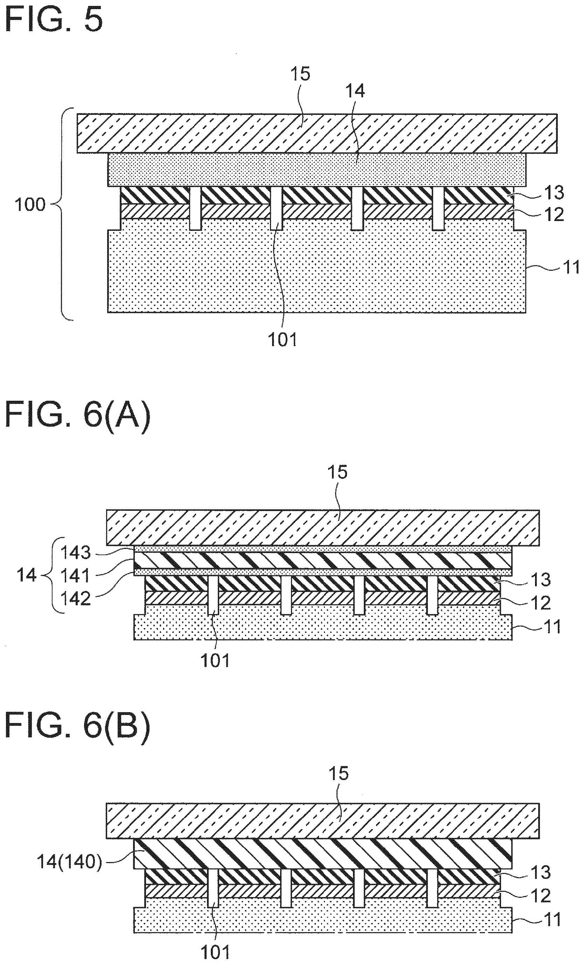

In the subsequent step S105 (FIG. 1), the supports 13 on the semiconductor layers 12 are joined to a glass substrate 15 via an adhesive member 14. FIG. 5 is a cross-sectional view schematically showing a state in which the support 13 has been joined to the glass substrate 15 via the adhesive member 14.

The glass substrate 15 is a retention substrate that holds the sapphire substrate 11, the semiconductor layers 12 and the supports 13. Incidentally, a retention substrate made of a different material may be used instead of the glass substrate as long as the substrate has sufficient strength and solvent resistance required of a retention substrate.

By joining the supports 13 to the glass substrate 15 by using the adhesive member 14, a semiconductor substrate 100 including the sapphire substrate 11, the plurality of islands (stacked structures) each including the semiconductor layer 12 and the support 13, the adhesive member 14 and the glass substrate 15 is formed.

The adhesive member 14 is softer than the semiconductor layer 12 and the support 13. Part or the whole of the adhesive member 14 is formed of an adhesive layer which will be described later, and the adhesive layer has viscoelasticity. When the islands (each including the semiconductor layer 12 and the support 13) and the adhesive member 14 receive a load in a stacking direction of the semiconductor layer 12 and the support 13 via the glass substrate 15 and the like, the adhesive member 14 is more likely to deform than the semiconductor layers 12 and the supports 13.

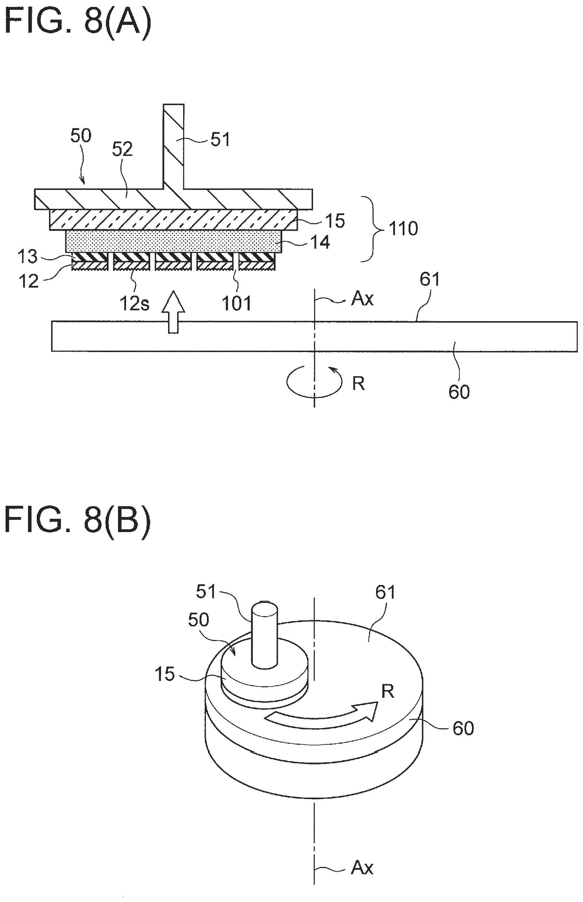

Thus, when the islands each including the semiconductor layer 12 and the support 13 and the adhesive member 14 receive a load in the stacking direction from a carrier 50 (FIG. 8(A)) of a polishing device in a polishing process which will be described later, for example, the adhesive member 14 is likely to deform and is capable of absorbing stress or the like applied to the semiconductor layers 12.

FIGS. 6(A) and 6(B) are cross-sectional views schematically showing configuration examples of the adhesive member 14. In the example shown in FIG. 6(A), the adhesive member 14 is configured as an adhesive sheet. In this case, the adhesive member 14 includes a base member 141, a first adhesive layer 142 provided on a surface of the base member 141 facing the support 13, and a second adhesive layer 143 provided on a surface of the base member 141 facing the glass substrate 15.

The base member 141 is desired to have a Young's modulus greater than or equal to 1 GPa. The material of the base member 141 is polyethylene terephthalate, polyethylene naphthalate, polybutylene terephthalate, polyester, polyamide, polycarbonate, polyacetal, polyphenylene sulphide, polysulfone, polyether ketone, or the like, for example.

When the base member 141 is formed of polyester (for example, polyethylene terephthalate (PET)), the Young's modulus is 4.6 to 5.1 GPa, for example. The thickness of the base member 141 is 100 µm, for example.

Each of the adhesive layers 142 and 143 is formed of an adhesive whose storage elastic modulus at 50 °C is 0.03 to 0.15 MPa. The thickness of each of the adhesive layers 142 and 143 is approximately 1 µm to 10 µm. The material of the adhesive layers 142 and 143 is an acrylic-based adhesive, a rubber-based adhesive, a vinyl alkyl ether-based adhesive, a silicone-based adhesive, a polyester-based adhesive, a polyamide-based adhesive, a urethane-based adhesive, a fluorine-based adhesive or an epoxy-based adhesive, for example.

In a case where the adhesive member 14 is an adhesive sheet, the thickness of the adhesive member 14 is greater than the sum of the thickness of the semiconductor layer 12 (1 µm to 10 µm) and the thickness of the support 13 (10 µm to 100 µm).

As such an adhesive member 14 (adhesive sheet), an adhesive sheet of a thermal release type can be used, for example. The adhesive sheet of the thermal release type exhibits adhesive force at a normal temperature and loses the adhesive force when heated, and thus removal of the adhesive member 14 (step S109) which will be described later can be executed with ease.

In contrast, in the example shown in FIG. 6(B), the adhesive member 14 includes no base member and is formed of one layer that is an adhesive layer 140. The thickness, the material and the storage elastic modulus of the adhesive layer 140 are the same as those of the adhesive layers 142 and 143 shown in FIG. 6(A) .

### <Process of Peeling off Semiconductor Layer>

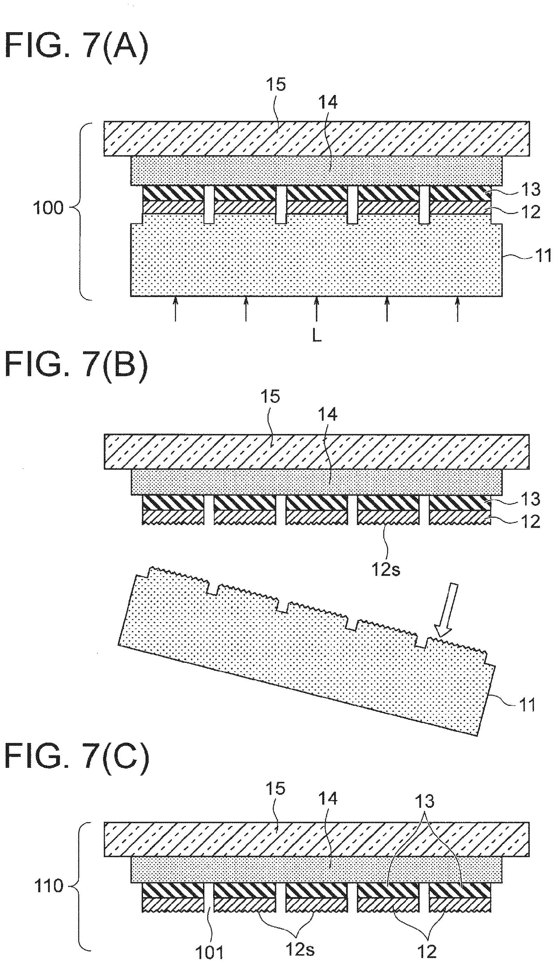

In the subsequent step S106 (FIG. 1), the semiconductor layer 12 is peeled off from the sapphire substrate 11 by applying laser light to the semiconductor layer 12. FIGS. 7(A) to 7(C) are cross-sectional views schematically showing the process of peeling off the semiconductor layer 12 from the sapphire substrate 11.

Since the sapphire substrate 11 transmits the laser light, the laser light (represented by the reference character L) can be applied to the semiconductor layer 12 from the sapphire substrate 11 side of the semiconductor substrate 100 as shown in FIG. 7(A).

The laser light is applied to the interface between the sapphire substrate 11 and the semiconductor layer 12, and the part of the semiconductor layer 12 irradiated with the laser light is heated locally and sublimates. Accordingly, the semiconductor layer 12 peels off from the sapphire substrate 11 as shown in FIG. 7(B). The method of peeling off the semiconductor layer 12 from the sapphire substrate 11 by using laser light as above is referred to as laser lift-off.

By this process, an intermediate structure (pre-polishing structure) 110 in which a plurality of islands each including the semiconductor layer 12 and the support 13 are supported by the glass substrate 15 via the adhesive member 14 is obtained. A surface 12s of each semiconductor layer 12 peeled off from the sapphire substrate 11 (joint surface to be joined to a silicon substrate 21 in step S108 which will be described later) has great surface roughness due to the laser light irradiation in the peeling process.

### <Process of Polishing Semiconductor Layer>

In the subsequent step S107 (FIG. 1), the surfaces 12s of the semiconductor layers 12 are polished. FIGS. 8(A) and 8(B) are a cross-sectional view and a perspective view schematically showing the process of polishing the surfaces 12s of the semiconductor layers 12.

As shown in FIG. 8(A), the polishing device includes a carrier 50 that holds the intermediate structure 110 and a polishing plate 60 that polishes the semiconductor layers 12 of the intermediate structure 110. The carrier 50 includes, for example, a disk part 52 facing the polishing plate 60 and a support shaft 51 that supports the disk part 52. In the polishing process, the glass substrate 15 of the intermediate structure 110 is fixed to the base of the disk part 52 of the carrier 50.

As shown in FIG. 8(B), the polishing plate 60 has a polishing pad 61 on its surface and rotates in the direction indicated by the arrow R about a rotation axis Ax orthogonal to the surface. It is also possible to rotate the carrier 50 about the support shaft 51 in addition to the rotation of the polishing plate 60.

The carrier 50 is pressed against the polishing plate 60, and the surfaces 12s of the semiconductor layers 12 are pressed against the polishing pad 61 of the polishing plate 60. Slurry containing abrasive grains (abradant) is supplied onto the polishing pad 61 of the polishing plate 60.

Chemical mechanical polishing (CMP) is used as the polishing method. CMP is a technique for obtaining an especially smooth polished surface by enhancing the mechanical polishing (surface removal) effect of the relative motion of the slurry and the polishing target object by use of a surface chemical function of the abrasive grains or a function of a chemical component contained in the slurry.

In this first embodiment, the slurry flows in the grooves 101 between the islands each including the semiconductor layer 12 and the support 13, and thus the polishing effect is enhanced. Therefore, the surface 12s of each semiconductor layer 12 can be smoothed with ease so that the surface roughness thereof becomes less than or equal to 10 nm.

Further, since the semiconductor layer 12 is supported by the support 13 having a greater thickness and a lower Young's modulus than the semiconductor layer 12, the load (stress or the like) acting on the semiconductor layer 12 at the time of the polishing is reduced and the occurrence of cracking or chipping of the surface 12s of the semiconductor layer 12 can be prevented.

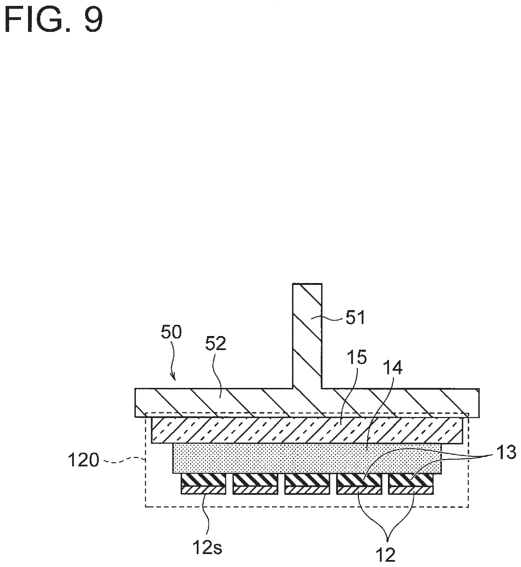

By the above-described polishing process, a semiconductor layer support structure 120 in which a plurality of islands each including the semiconductor layer 12 and the support 13 are supported by the glass substrate 15 via the adhesive member 14 is obtained as shown in FIG. 9.

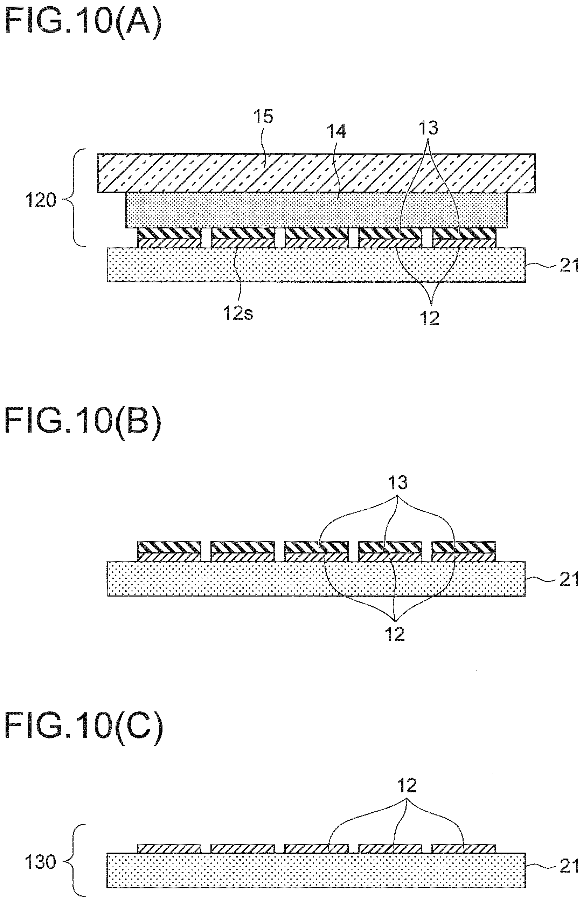

FIGS. 10(A), 10(B) and 10(C) are schematic diagrams showing a process of joining the semiconductor layers 12 to the silicon substrate 21, a process of removing the adhesive member 14 and a process of removing the supports 13.

### <Process of Joining to Silicon Substrate>

In the subsequent step S108 (FIG. 1), the surfaces 12s of the semiconductor layers 12 of the semiconductor layer support structure 120 detached from the carrier 50 are joined to the silicon substrate 21 as a transfer substrate as shown in FIG. 10 (A) .

The silicon substrate 21 is a substrate formed of silicon (Si) and is a substrate of a type different from the sapphire substrate 11 as the growth substrate. Since the surface 12s of each semiconductor layer 12 has high smoothness with surface roughness less than or equal to 10 nm, the surface 12s is joined to the surface of the silicon substrate 21 by intermolecular force.

Incidentally, a wiring pattern or the like may be previously formed on the silicon substrate 21. Further, it is also possible to use a transfer substrate made of a different material instead of the silicon substrate 21.

### <Process of Removing Adhesive Member>

In the subsequent step S109 (FIG. 1), the adhesive member 14 is removed as shown in FIG. 10 (B). In the case where the adhesive sheet of the thermal release type (FIG. 6(A)) is used as the adhesive member 14, the adhesive member 14 can be peeled off from the supports 13 by erasing the adhesive force of the adhesive member 14 by heating the adhesive member 14 up to a prescribed temperature.

In the case where the adhesive member 14 is the adhesive layer 140 (FIG. 6(B)), the adhesive member 14 can be removed by dissolving the adhesive layer 140 in a solvent (chemical), for example.

### <Process of Removing Support>

In the subsequent step S110 (FIG. 1), the supports 13 on the semiconductor layers 12 are removed as shown in FIG. 10(C). The supports 13 can be removed by dissolving the supports 13 in an organic solvent, for example.

By the removal of the supports 13, a base substrate 130 in which a plurality of semiconductor layers 12 are arrayed in a grid on the silicon substrate 21 is obtained. The semiconductor layer 12 is referred to also as a semiconductor element.

The semiconductor layer 12 of the base substrate 130 is made into an LED, for example, by forming the mesa structure by means of patterning and forming electrodes or a wiring pattern. By this process, a micro-LED display device in which LEDs are arrayed in a grid on the silicon substrate 21 is formed, for example.

### <Function>

There has been known a technology of peeling off a semiconductor layer, formed on a growth substrate by epitaxial growth, from the growth substrate, and transferring the semiconductor layer to a different substrate. When a sapphire substrate is used as the growth substrate, the sapphire substrate transmits the laser light, and thus it is advantageous to peel off the semiconductor layer from the sapphire substrate by the irradiation with the laser light.

However, the surface of the semiconductor layer peeled off from the sapphire substrate by the laser light irradiation is likely to become rough. Therefore, the surface of the semiconductor layer needs to be smoothed by CMP polishing or the like. Especially when the peeled semiconductor layer is joined to a different substrate by intermolecular force, the smoothness of the surface (joint surface) of the semiconductor layer has to be made sufficiently high.

On the other hand, if the polishing rate is raised or the polishing time is made longer in order to increase the smoothness, the load acting on the surface of the semiconductor layer becomes high and the cracking or chipping is likely to occur on the surface of the semiconductor layer. Therefore, it is requested to reduce the load on the semiconductor layer at the time of the polishing while increasing the smoothness of the surface of the semiconductor layer.

In this first embodiment, as shown in FIG. 8(A), the surfaces 12s of the semiconductor layers 12 are polished in a state in which the plurality of islands previously separated (singulated) and each including the semiconductor layer 12 and the support 13 are held by the glass substrate 15 via the adhesive member 14.

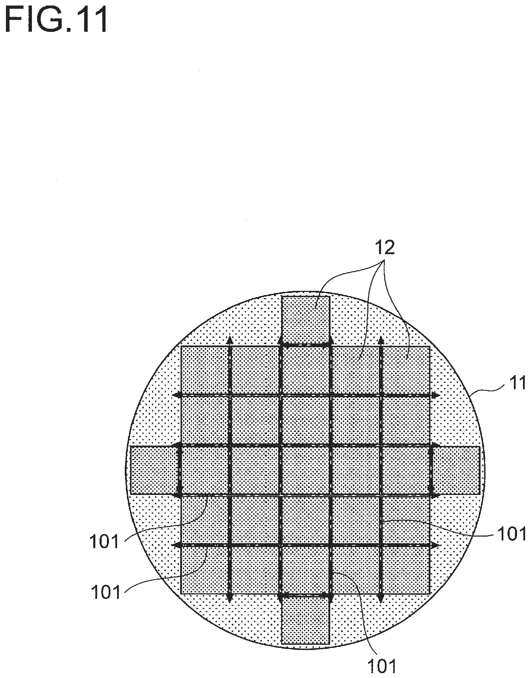

FIG. 11 is a diagram schematically showing the flow of the slurry supplied onto the polishing pad 61 in the polishing process. The slurry supplied onto the polishing pad 61 in the polishing process flows in the grooves 101 between the islands (each including the semiconductor layer 12 and the support 13) arrayed in a grid.

Therefore, the slurry can be evenly fed to the surfaces 12s of all the semiconductor layers 12 and these surfaces 12s can be polished sufficiently. Accordingly, the surface 12s of each semiconductor layer 12 can be smoothed with ease so that the surface roughness thereof becomes less than or equal to 10 nm, for example.

Further, since the semiconductor layer 12 is supported by the support 13 having a greater thickness and a lower Young's modulus than the semiconductor layer 12, the stress or the like applied to the semiconductor layer 12 in the polishing process can be absorbed by the support 13 and the load acting on the semiconductor layer 12 can be reduced.

Furthermore, the adhesive member 14 is softer than the semiconductor layer 12 and the support 13. In other words, the adhesive member 14 is more likely to be deformed than the semiconductor layer 12 and the support 13 by a load in the stacking direction of the semiconductor layer 12 and the support 13 (vertical direction in FIG. 8(A)). Therefore, the stress or the like applied to the semiconductor layer 12 at the time of the polishing is likely to be absorbed by the adhesive member 14 and the load acting on the semiconductor layer 12 can be reduced further.

Moreover, in the case where the adhesive member 14 is the adhesive sheet (FIG. 6(A)), the load acting on the semiconductor layer 12 can be reduced further by setting the thickness of the adhesive member 14 greater than the sum of the thickness of the semiconductor layer 12 and the thickness of the support 13.

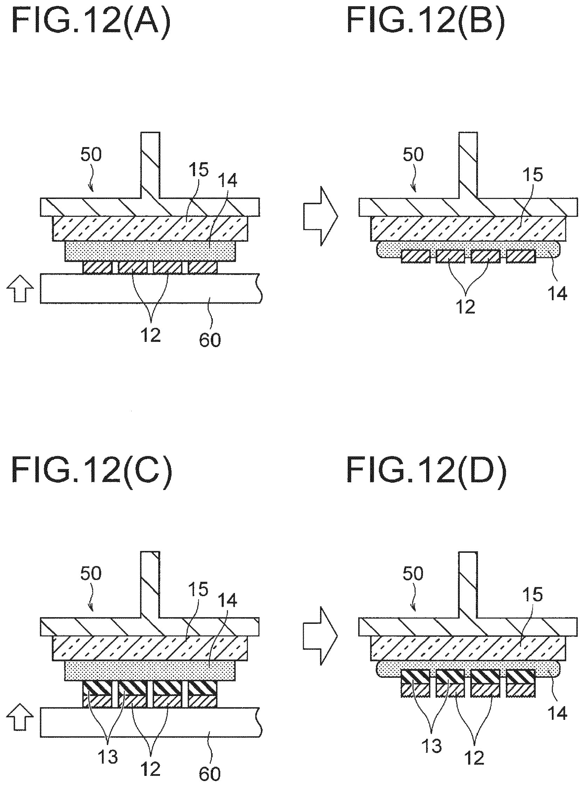

FIGS. 12(A) and 12(B) show a polishing state in a comparative example. In the comparative example, the polishing is executed by holding the semiconductor layers 12 by the glass substrate 15 via the adhesive member 14 without providing the supports 13. FIGS. 12(C) and 12(D) show a polishing state in the first embodiment.

In the comparative example, the semiconductor layers 12 are held by the glass substrate 15 via the adhesive member 14 as shown in FIG. 12 (A) . Therefore, the semiconductor layers 12 are likely to sink into the adhesive member 14 as shown in FIG. 12(B) due to pressure applied from the polishing plate 60 to the semiconductor layers 12. As a result, there is a possibility that the contact between the surface of the semiconductor layer 12 and the polishing plate 60 becomes insufficient and the polishing rate decreases.

In contrast, in the first embodiment, the supports 13 on the semiconductor layers 12 are held by the glass substrate 15 via the adhesive member 14 as shown in FIG. 12(C). Therefore, the sinking of the semiconductor layers 12 into the adhesive member 14 is unlikely to occur as shown in FIG. 12 (D). As a result, the contact between the surface of the semiconductor layer 12 and the polishing plate 60 is secured sufficiently and a sufficient polishing rate is secured.

As above, in the first embodiment, the smoothness of the surfaces of the semiconductor layers 12 can be increased further by forming the supports 13. Further, since the time necessary for the polishing can be shortened by the increase in the polishing rate, the load on the semiconductor layers 12 due to a long polishing time can be reduced.

### <Effect of First Embodiment>

As described above, the manufacturing method of the semiconductor element in the first embodiment includes the formation process of forming a plurality of islands, each including the semiconductor layer 12 containing a nitride semiconductor and the support 13 formed on the semiconductor layer 12, on the sapphire substrate 11, the joining process of joining the supports 13 to the glass substrate 15 (retention substrate) via the adhesive member 14, the peeling process of peeling off the semiconductor layers 12 from the sapphire substrate 11 by irradiating the semiconductor layers 12 with laser light, and the polishing process of polishing the surfaces 12s of the semiconductor layers 12.

Since the semiconductor layer 12 is supported by the support 13 as above, the load acting on the semiconductor layer 12 in the polishing process can be reduced. Further, since the slurry flows in the grooves 101 between the plurality of islands (each including the semiconductor layer 12 and the support 13), the surface 12s of the semiconductor layer 12 can be polished sufficiently. Namely, the load acting on the surface 12s of the semiconductor layer 12 can be reduced while increasing the smoothness of the surface 12s of the semiconductor layer 12.

Further, the aforementioned islands (each including the semiconductor layer 12 and the support 13) are formed by forming the semiconductor thin-film layer 12a on the sapphire substrate 11, separating (singulating) the semiconductor thin-film layer 12a into a plurality of semiconductor layers 12, forming the support layer 13a to cover the semiconductor layers 12, and separating the support layer 13a into a plurality of supports 13 corresponding to the semiconductor layers 12. Therefore, the patterning of the semiconductor layers 12 and the supports 13 differing from each other in the material can be executed by respectively suitable methods and by using the same mask.

Since the thickness of the support 13 is greater than the thickness of the semiconductor layer 12 and the Young's modulus of the support 13 is lower than the Young's modulus of the semiconductor layer 12, the stress or the like applied to the semiconductor layer 12 at the time of the polishing is likely to be absorbed by the support 13 and the load acting on the semiconductor layer 12 can be reduced effectively.

In the case where the adhesive sheet including the base member 141 and the adhesive layers 142 and 143 is used as the adhesive member 14, handling of the adhesive member 14 in the manufacturing process is facilitated and the adhesive member 14 can be removed from the supports 13 with ease.

The semiconductor substrate 100 (FIG. 5) as an intermediate product includes the sapphire substrate 11, the plurality of islands each including the semiconductor layer 12 and the support 13, the adhesive member 14, and the glass substrate 15 as the retention substrate. Therefore, by separating the semiconductor layers 12 of the semiconductor substrate 100 from the sapphire substrate 11 and further polishing the semiconductor layers 12, it becomes possible to join the semiconductor layers 12 to the silicon substrate 21.

The semiconductor layer support structure 120 (FIG. 9) as an intermediate product includes the plurality of islands each including the semiconductor layer 12 and the support 13, the adhesive member 14, and the glass substrate 15 as the retention substrate. Therefore, the semiconductor layers 12 of the semiconductor layer support structure 120 can be joined to the silicon substrate 21.

### (Second Embodiment)

Next, a second embodiment will be described below. The second embodiment differs from the first embodiment in using a support 16 having double-layer structure instead of the support 13.

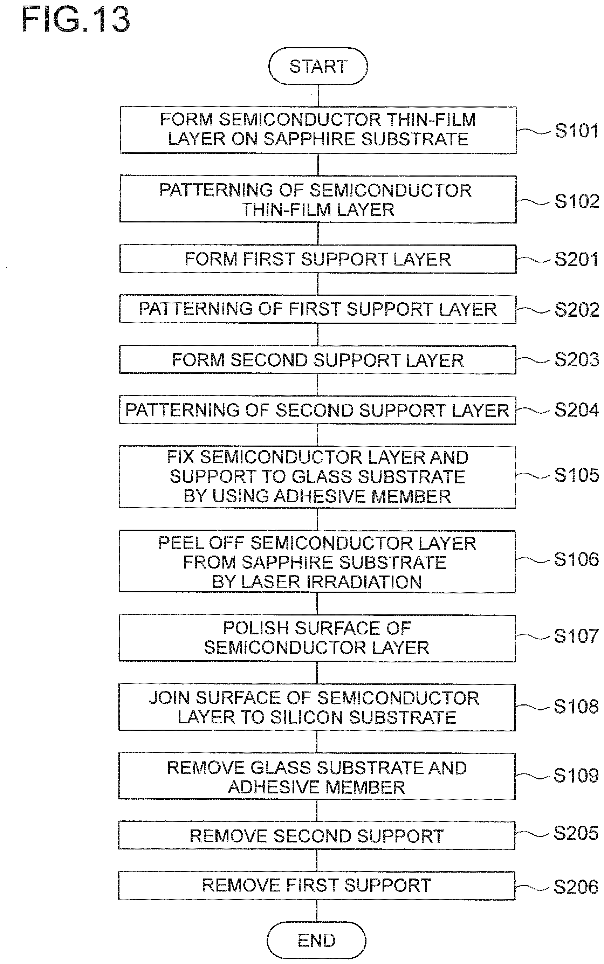

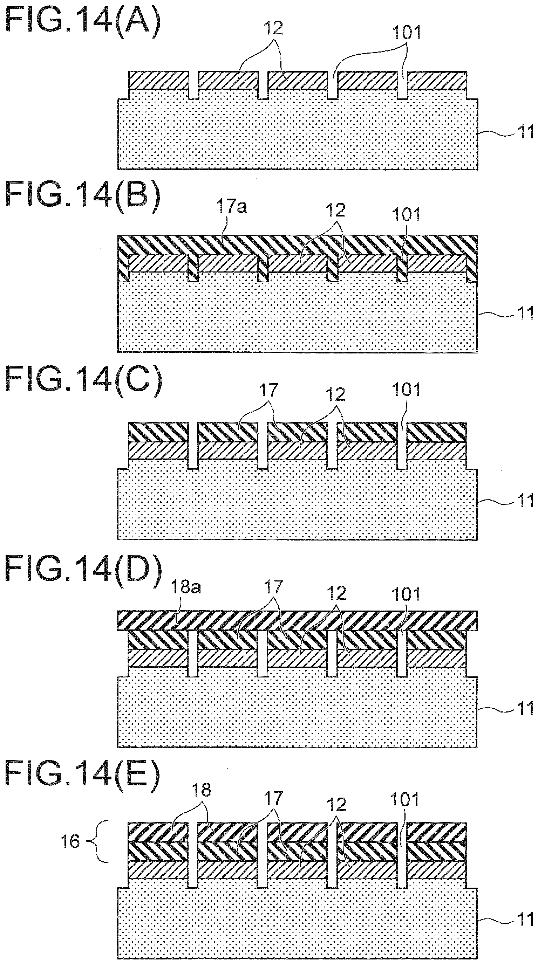

FIG. 13 is a flowchart showing a manufacturing method of a semiconductor element in the second embodiment. FIGS. 14(A) to 14(E) are diagrams schematically showing a process of singulating the semiconductor thin-film layer 12a, processes of forming a first support layer 17a and singulating the first support layer 17a, and processes of forming a second support layer 18a and singulating the second support layer 18a. FIGS. 14(A) to 14(E) correspond to cross-sectional views taken along the line 4A - 4A shown in FIG. 3.

The process of forming the semiconductor thin-film layer 12a on the sapphire substrate 11 (S101) is as described in the first embodiment. Further, the process of separating the semiconductor thin-film layer 12a into a plurality of semiconductor layers 12 as shown in FIG. 14 (A) (S102) is also as described in the first embodiment.

### <Process of Forming First Support Layer>

In the subsequent step S201 (FIG. 13), as shown in FIG. 14(B), the first support layer 17a is formed to cover the semiconductor layers 12 separated on the sapphire substrate 11. The first support layer 17a is formed of an inorganic material (inorganic film) such as Si₃N₄ or SiO₂ or an organic material (organic film) such as a novolac resist, for example. Incidentally, the first support layer 17a may also fill in the grooves 101 between the semiconductor layers 12 depending on the material pf the first support layer 17a.

### <Process of Singulating First Support Layer>

In the subsequent step S202 (FIG. 13), as shown in FIG. 14(C), the first support layer 17a is patterned by means of photolithography and thereby separated (singulated) into a plurality of first supports 17 similarly to the semiconductor layers 12. Namely, the first supports 17 are separated from each other by the grooves 101 similarly to the semiconductor layers 12.

The thickness of the first support 17 is 1 µm to 10 µm, for example, which is equivalent to the thickness of the semiconductor layer 12. The Young's modulus of the first support 17 is lower than or equal to the Young's modulus of the semiconductor layer 12, and is higher than the Young's modulus of a second support 18 which will be described next.

### <Process of Forming Second Support Layer>

In the subsequent step S203 (FIG. 13), the second support layer 18a is formed to cover the first supports 17 as shown in FIG. 14(D). The second support layer 18a is formed of an organic material (organic film) such as acrylic, for example.

### <Process of Singulating Second Support Layer>

In the subsequent step S204 (FIG. 13), as shown in FIG. 14(E), the second support layer 18a is patterned by means of photolithography and thereby separated (singulated) into a plurality of second supports 18 similarly to the first supports 17. Namely, the second supports 18 are separated from each other by the grooves 101 similarly to the first supports 17.

The thickness of the second support 18 is 10 µm to 100 µm, for example. The Young's modulus of the second support 18 is lower than the Young's modulus of the semiconductor layer 12 and is 3.2 GPa, for example.

By this process, a plurality of islands (stacked structures) each formed by stacking the semiconductor layer 12, the first support 17 and the second support 18 are formed on the sapphire substrate 11. The first support 17 and the second support 18 are also referred to collectively as a support 16.

The sum of the thickness of the first support 17 and the thickness of the second support 18 is greater than the thickness of the semiconductor layer 12 (for example, 1 µm to 10 µm), and is desired to be greater than or equal to twice the thickness of the semiconductor layer 12.

Further, while the Young's modulus of the first support 17 is lower than or equal to the Young's modulus of the semiconductor layer 12, the Young's modulus of the second support 18 is lower than the Young's modulus of the semiconductor layer 12 (for example, 200 GPa). In other words, the second support 18 is softer and more likely to deform than the semiconductor layer 12.

### <Process of Joining to Glass Substrate>

In the subsequent step S105 (FIG. 13), the second supports 18 on the semiconductor layers 12 are joined to the glass substrate 15 via the adhesive member 14 as described in the first embodiment. The adhesive member 14 is as described in the first embodiment.

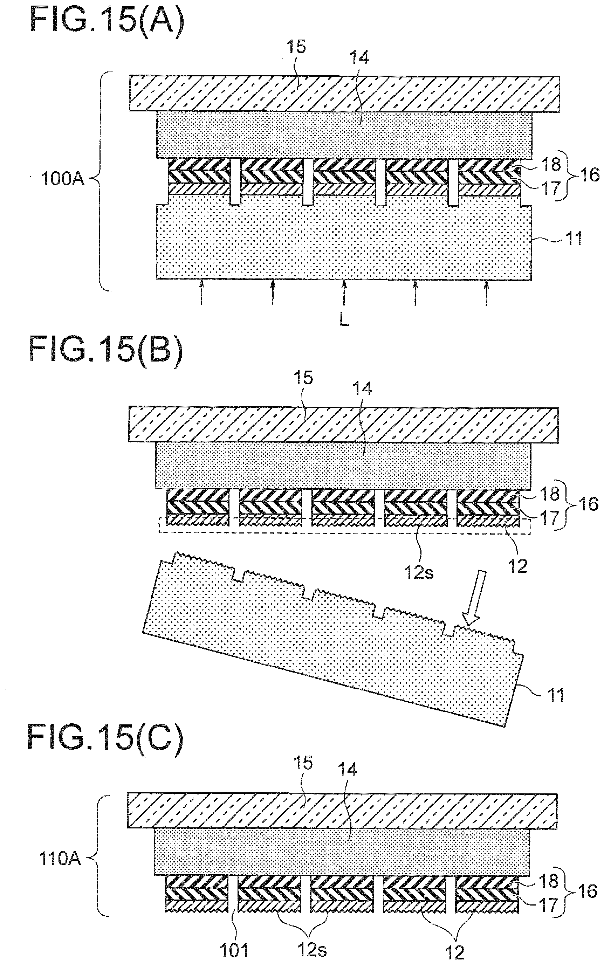

By joining the second supports 18 to the glass substrate 15 by using the adhesive member 14, a semiconductor substrate 100A (see FIG. 15(A)) including the sapphire substrate 11, the plurality of islands (stacked structures) each including the semiconductor layer 12, the first support 17 and the second support 18, the adhesive member 14 and the glass substrate 15 is formed.

The specific configuration of the adhesive member 14 is as described with reference to FIGS. 6(A) and 6(B) in the first embodiment. The adhesive member 14 is softer than the semiconductor layer 12, the first support 17 and the second support 18.

Further, in the case where the adhesive member 14 is the adhesive sheet (FIG. 6(A)), the thickness of the adhesive member 14 is greater than the sum of the thickness of the semiconductor layer 12 (1 µm to 10 µm), the thickness of the first support 17 (1 µm to 10 µm) and the thickness of the second support 18 (10 µm to 100 µm).

### <Process of Peeling off Semiconductor Layer>

In the subsequent step S106 (FIG. 13), the semiconductor layer 12 is peeled off from the sapphire substrate 11 by applying laser light to the semiconductor layer 12. FIGS. 15(A) to 15(C) are cross-sectional views schematically showing the process of peeling off the semiconductor layer 12 from the sapphire substrate 11.

As shown in FIG. 15(A), the laser light is applied to the semiconductor layer 12 from the sapphire substrate 11 side of the semiconductor substrate 100A. Accordingly, the semiconductor layers 12 peel off from the sapphire substrate 11 as shown in FIG. 15 (B) .

By this process, an intermediate structure (pre-polishing structure) 110A including a plurality of islands each including the semiconductor layer 12, the first support 17 and the second support 18, the adhesive member 14 and the glass substrate 15 is obtained.

### <Process of Polishing Semiconductor Layer>

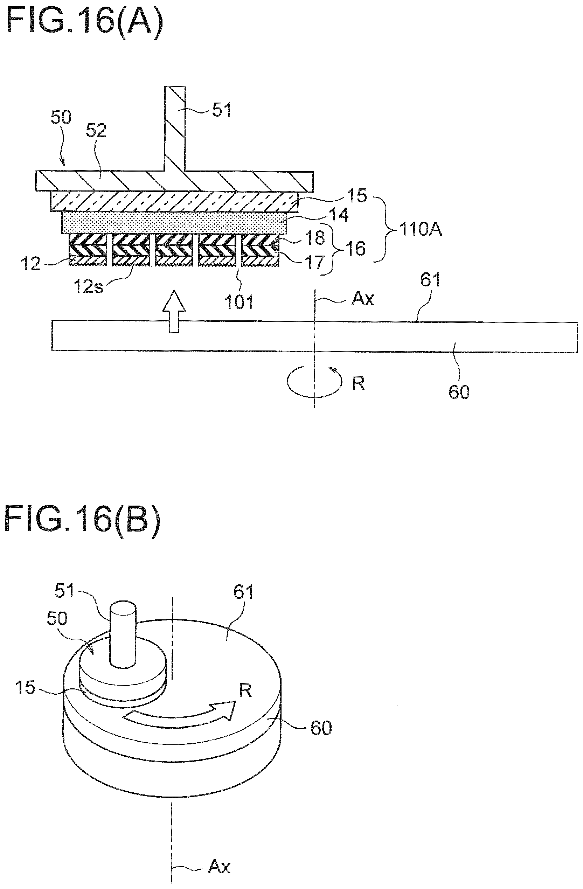

In the subsequent step S107 (FIG. 13), the surfaces 12s of the semiconductor layers 12 are polished. FIGS. 16(A) and 16(B) are a cross-sectional view and a perspective view schematically showing the process of polishing the surfaces 12s of the semiconductor layers 12.

As shown in FIG. 16(A), in the polishing process, the glass substrate 15 of the intermediate structure 110A is fixed to the carrier 50 of the polishing device. The polishing device and the polishing method are as described in the first embodiment.

In the polishing process, the slurry flows in the grooves 101 between the islands each including the semiconductor layer 12, the first support 17 and the second support 18, and thus the slurry is fed to the surfaces 12s of all the semiconductor layers 12 and the polishing effect is enhanced. Accordingly, the surfaces 12s of the semiconductor layers 12 can be smoothed so that the surface roughness becomes less than or equal to 10 nm.

Further, since the semiconductor layer 12 is supported via the second support 18 having a greater thickness and a lower Young's modulus than the semiconductor layer 12, the load applied to the semiconductor layer 12 at the time of the polishing is reduced and the occurrence of the cracking or chipping of the surface 12s of the semiconductor layer 12 can be prevented.

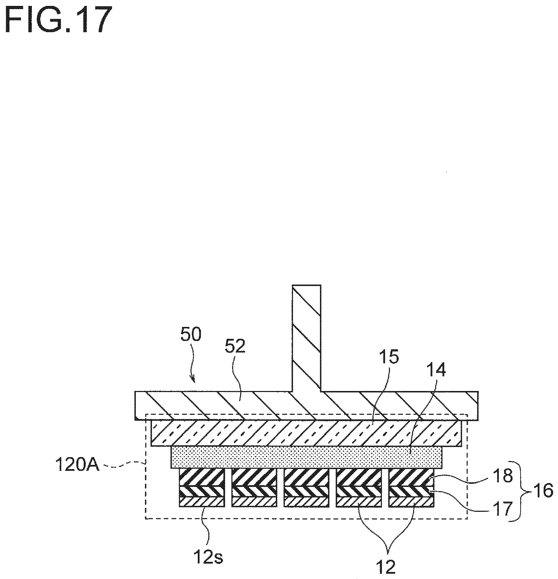

By the above-described polishing process, a semiconductor layer support structure 120A including a plurality of islands each including the semiconductor layer 12, the first support 17 and the second support 18, the adhesive member 14 and the glass substrate 15 is obtained as shown in FIG. 17.

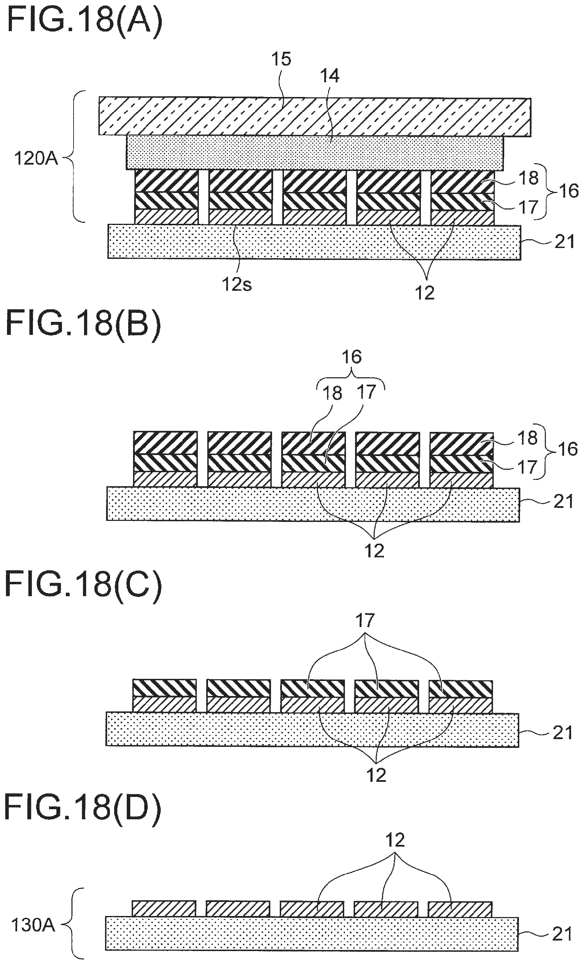

FIGS. 18(A), 18(B), 18(C) and 18(D) are schematic diagrams showing a process of joining the semiconductor layers 12 to the silicon substrate 21, a process of removing the adhesive member 14, a process of removing the second supports 18 and a process of removing the first supports 17.

### <Process of Joining to Silicon Substrate>

In the subsequent step S108 (FIG. 13), the surfaces 12s of the semiconductor layers 12 of the semiconductor layer support structure 120A detached from the carrier 50 are joined to the silicon substrate 21 as the transfer substrate as shown in FIG. 18 (A) . The surfaces 12s of the semiconductor layers 12 are joined to the surface of the silicon substrate 21 by intermolecular force.

### <Process of Removing Adhesive Member>

In the subsequent step S109 (FIG. 13), the adhesive member 14 is removed as shown in FIG. 18 (B). In the case where the adhesive sheet of the thermal release type (FIG. 6(A)) is used as the adhesive member 14, the adhesive member 14 can be peeled off from the supports 13 by erasing the adhesive force of the adhesive member 14 by heating the adhesive member 14 up to a prescribed temperature. In the case where the adhesive member 14 is the adhesive layer 140 (FIG. 6(B)), the adhesive member 14 can be removed by dissolving the adhesive layer 140 in a solvent (chemical), for example.

### <Process of Removing Second Support>

In the subsequent step S205 (FIG. 13), the second support 18 is removed as shown in FIG. 18 (C) . The second support 18 can be removed by dissolving the second support 18 in an organic solvent, for example.

### <Process of Removing First Support>

In the subsequent step S206 (FIG. 13), the first support 17 is removed as shown in FIG. 18(D). When the first support 17 is an organic film of acrylic or the like, the first support 17 can be dissolved in an organic solvent. When the first support 17 is an inorganic film of Si₃N₄, SiO₂ or the like, the first support 17 can be dissolved in an acidic solution such as hydrofluoric acid (HF), for example.

By the removal of the first supports 17 and the second supports 18, a base substrate 130A in which a plurality of semiconductor layers 12 are arrayed in a grid on the silicon substrate 21 is obtained as shown in FIG. 18(D). The semiconductor layer 12 is referred to also as the semiconductor element. The semiconductor layer 12 of the base substrate 130A is patterned as described in the first embodiment and thereby made into an LED, for example.

Incidentally, while the first supports 17 and the second supports 18 are removed by different processes in this example, it is also possible to remove the first supports 17 and the second supports 18 by a single process. Further, while each support 16 in this example is formed with two layers, i.e., the first support 17 and the second support 18, it is also possible to form the support 16 with three or more layers.

### <Effect of Second Embodiment>

As described above, in the second embodiment, the semiconductor layer 12 is supported via the first support 17 and the second support 18. The second support 18 has a greater thickness and a lower Young's modulus as compared to the semiconductor layer 12, and thus the load acting on the semiconductor layer 12 in the polishing process can be reduced. Further, since the first support 17 functions as a cushioning material between the semiconductor layer 12 and the second support 18, the load acting on the semiconductor layer 12 can be reduced further.

### (Third Embodiment)

Next, a third embodiment will be described below. The third embodiment differs from the first embodiment in that the semiconductor layers 12 include dummy parts D1 to D8 in addition to the chip parts P1 to P29 and supports 13 (represented by reference characters E1 to E4) covering these dummy parts D1 to D8 are formed.

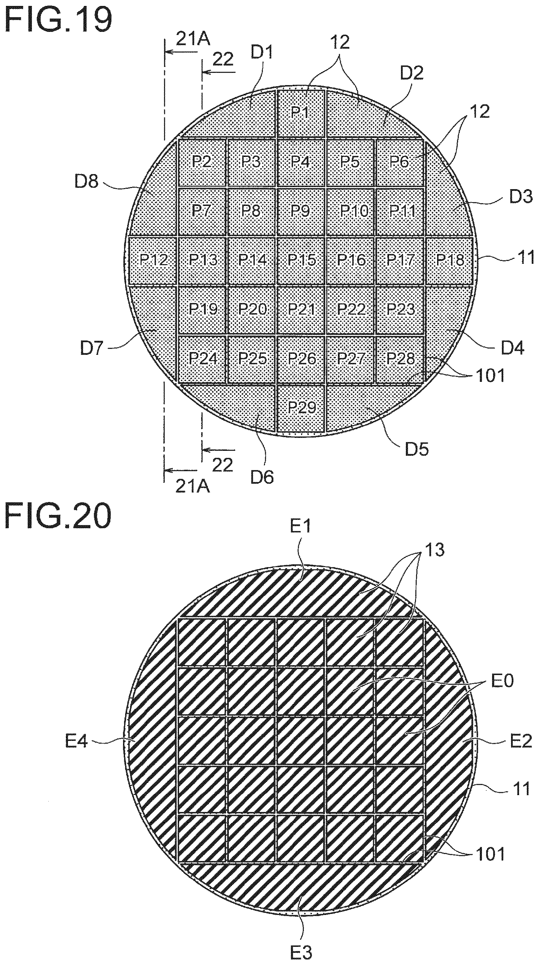

FIG. 19 is a plan view showing the semiconductor layers 12 separated (singulated) in the step S102 in FIG. 1. The semiconductor layers 12 include the dummy parts D1 to D8 along the outer circumference of the sapphire substrate 11 (wafer) in addition to the chip parts P1 to P29 described in the first embodiment. The dummy parts D1 to D8 are parts not used as LEDs or the like among the semiconductor layers 12.

The arrangement of the chip parts P1 to P29 is as described earlier with reference to FIG. 3. The dummy parts D1 and D2 are respectively formed on both sides of the chip part P1 in a row direction. The dummy parts D3 and D4 are respectively formed on both sides of the chip part P18 in a column direction. The dummy parts D5 and D6 are respectively formed on both sides of the chip part P29 in the row direction. The dummy parts D7 and D8 are respectively formed on both sides of the chip part P12 in the column direction.

Incidentally, the arrangement of the dummy parts of the semiconductor layers 12 is not limited to the example shown in FIG. 19. It is sufficient that at least one dummy part is formed on the sapphire substrate 11 and on the outer circumferential side relative to the chip parts.

FIG. 20 is a plan view showing the supports 13 separated (singulated) in the step S104 in FIG. 1. Twenty-five supports 13 (each represented by the reference character E0) are formed on the semiconductor layers 12 in five rows and five columns (referred to as chip parts P2 to P11, P13 to P17 and P19 to P28) situated on a central region of the sapphire substrate 11, and four supports 13 (reference characters E1 to E4) are formed on the outer circumferential side relative to the twenty-five supports 13.

The support 13 represented by the reference character E1 is formed to cover the chip part P1 and the dummy parts D1 and D2 on both sides of the chip part P1. The support 13 represented by the reference character E2 is formed to cover the chip part P18 and the dummy parts D3 and D4 on both sides of the chip part P18. The support 13 represented by the reference character E3 is formed to cover the chip part P29 and the dummy parts D5 and D6 on both sides of the chip part P29. The support 13 represented by the reference character E4 is formed to cover the chip part P12 and the dummy parts D7 and D8 on both sides of the chip part P12.

Thus, in the third embodiment, the size of each of the supports 13 (reference characters E1 through E4) formed on the outer circumferential region of the sapphire substrate 11 is larger than the size of each of the supports 13 (represented by the reference character EC) formed on the central region of the sapphire substrate 11.

### <Process of Forming Semiconductor Thin-film Layer to Process of Singulating Support Layer>

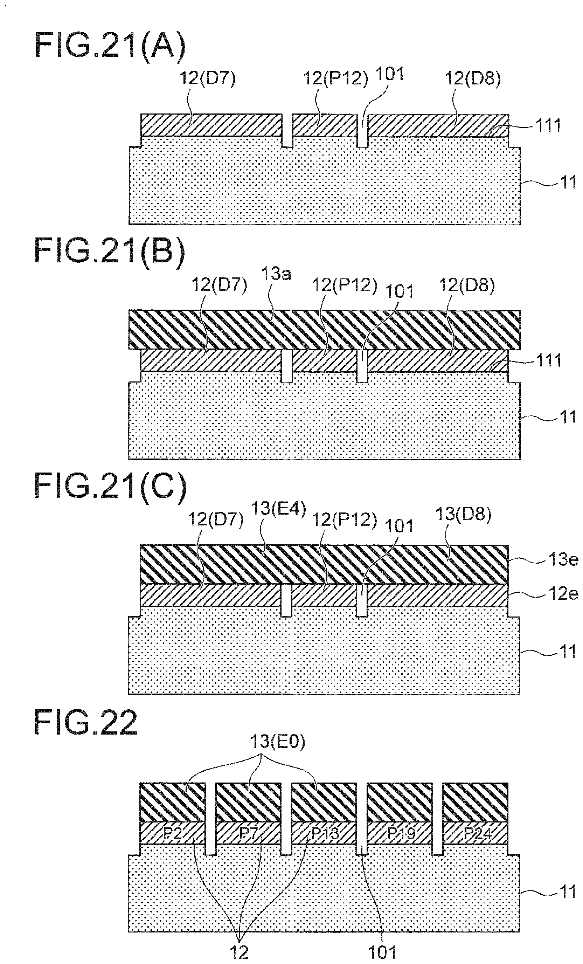

FIGS. 21(A) to 21(C) are diagrams schematically showing a process of singulating the semiconductor thin-film layer 12a, a process of forming the support layer 13a and a process of singulating the support layer 13a. FIGS. 21(A) to 21(C) correspond to cross-sectional views taken along the line 21A - 21A shown in FIG. 19.

The process of forming the semiconductor thin-film layer 12a on the sapphire substrate 11 is as described in the first embodiment. Further, the processes of separating (singulating) the semiconductor thin-film layer 12a into a plurality of semiconductor layers 12, forming the support layer 13a on the semiconductor layers 12, and separating (singulating) the support layer 13a into the supports 13 as shown in FIGS. 21(A), 21(B) and 21(C) are also as described in the first embodiment.

However, as shown in FIG. 21(C), each support 13 situated in the outer circumferential region of the sapphire substrate 11 (i.e., each of the supports 13 represented by the reference characters E1 to E4 in FIG. 20) is formed to straddle a chip part (for example, the chip part P12) among the semiconductor layers 12 and dummy parts (for example, the dummy parts D7 and D8) on both sides of the chip part.

FIG. 22 is a cross-sectional view schematically showing the same process as FIG. 21(C) and taken along the line 22 - 22 shown in FIG. 19. The supports 13 situated in the central region of the sapphire substrate 11 (i.e., the supports 13 represented by the reference character E0 in FIG. 20) are formed on their corresponding semiconductor layers 12 (for example, the chip parts P2, P7, P13, P19 and P24).

### <Process of Joining to Glass Substrate to Process of Peeling off Semiconductor Layer>

The process of joining the supports 13 to the glass substrate 15 via the adhesive member 14 and the process of peeling off the semiconductor layers 12 from the sapphire substrate 11 by the laser light irradiation are as described in the first embodiment.

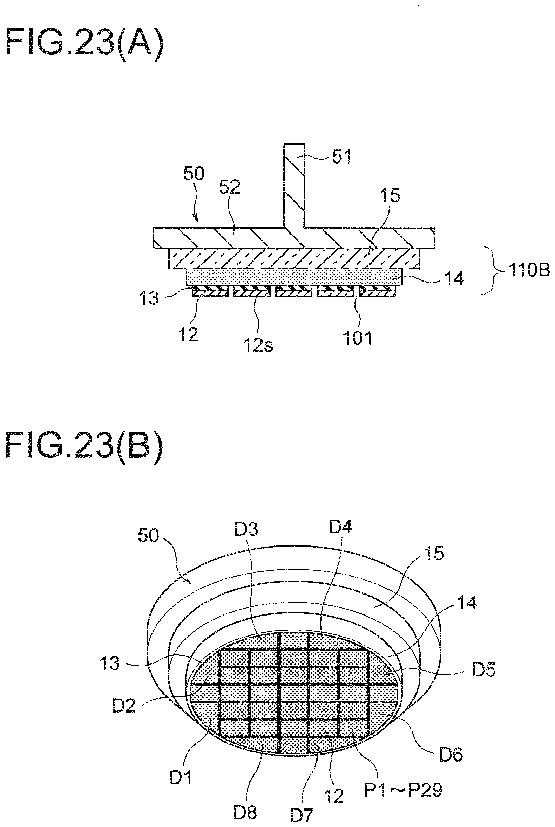

By the peeing from the sapphire substrate 11, an intermediate structure (pre-polishing structure) 110B including the semiconductor layers 12, the supports 13, the adhesive member 14 and the glass substrate 15 is formed (see FIG. 23(A)).

### <Process of Polishing Semiconductor Layer>

FIGS. 23(A) and 23(B) are a cross-sectional view and a perspective view schematically showing a process of polishing the surface 12s of the semiconductor layer 12. As shown in FIG. 23(A), in the polishing process, the glass substrate 15 of the intermediate structure 110B is fixed to the carrier 50 of the polishing device. The polishing device and the polishing method are as described in the first embodiment.

As shown in FIG. 23(B), the semiconductor layers 12 include the dummy parts D1 to D8 on the outer circumferential side of the sapphire substrate 11. Each of the supports 13 in the outer circumferential region of the sapphire substrate 11 (represented by the reference characters E1 to E4 in FIG. 20) has a larger area than each of the supports 13 in the central region (represented by the reference character E0 in FIG. 20).

Therefore, the stress or the like applied to the semiconductor layers 12 at the time of the polishing can be effectively absorbed by the supports 13 provided on substantially the whole surface of the sapphire substrate 11. Accordingly, the load acting on the semiconductor layer 12 can be reduced further and the occurrence of the cracking or chipping of the surface 12s of the semiconductor layer 12 can be prevented.

### <Process of Joining to Silicon Substrate to Process of Removing Support>

The process of joining the semiconductor layers 12 after the polishing to the silicon substrate 21, the process of removing the adhesive member 14 and the process of removing the supports 13 are as described in the first embodiment (see FIGS. 10(A) to 10(C)).

In the process of removing the supports 13, both of the supports 13 in the outer circumferential region of the sapphire substrate 11 (represented by the reference characters E1 to E4 in FIG. 20) and the supports 13 in the central region (represented by the reference character E0 in FIG. 20) are removed. By this process, a base substrate 130 in which a plurality of semiconductor layers 12 are arrayed in a grid on the silicon substrate 21 (see FIG. 10(C)) is obtained.

The semiconductor layer 12 of the base substrate 130 is patterned as described in the first embodiment and thereby made into an LED, for example. At this stage, the dummy parts D1 to D8 of the semiconductor layers 12 are also removed.

Also in the manufacturing method in this third embodiment, a semiconductor substrate and a semiconductor layer support structure similar to the semiconductor substrate 100 (FIG. 5) and the semiconductor layer support structure 120 (FIG. 9) in the first embodiment are produced. Difference is that the semiconductor layers 12 of the semiconductor substrate and the semiconductor layer support structure in the third embodiment include the dummy parts D1 to D8, and the supports 13 (reference characters E1 - E4) covering these dummy parts D1 to D8 are provided.

### <Effect of Third Embodiment>

As described above, in the third embodiment, the area of each support 13 situated in the outer circumferential region of the sapphire substrate 11 is larger than the area of each support 13 situated in the central region of the sapphire substrate 11. Therefore, the stress or the like applied to the semiconductor layer 12 at the time of the polishing can be effectively absorbed by the support 13 and the load acting on the semiconductor layer 12 can be reduced further.

Incidentally, the support 13 in the third embodiment may also have structure of two or more layers like the support 16 in the second embodiment.

### (Fourth Embodiment)

Next, a fourth embodiment will be described below. The fourth embodiment differs from the first embodiment in that a groove 43 is formed along an outer periphery of a semiconductor layer 40.

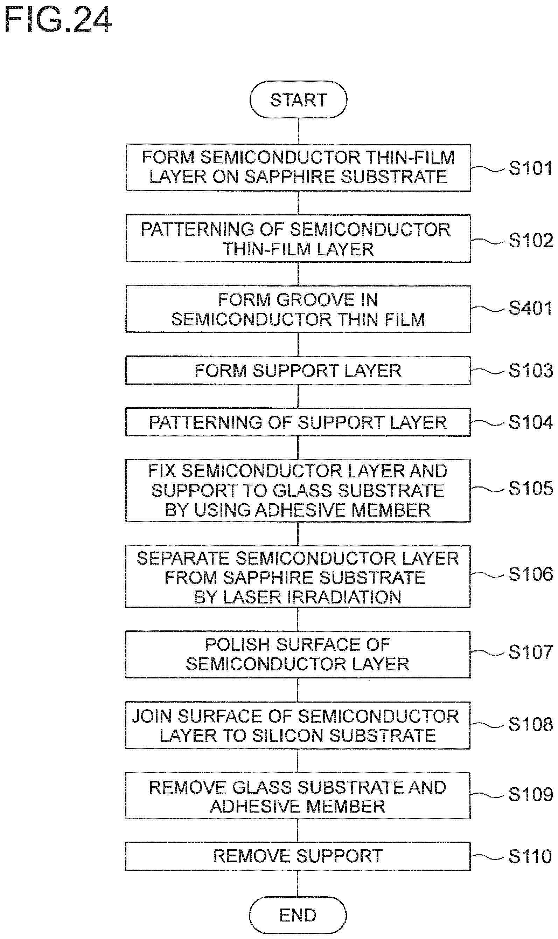

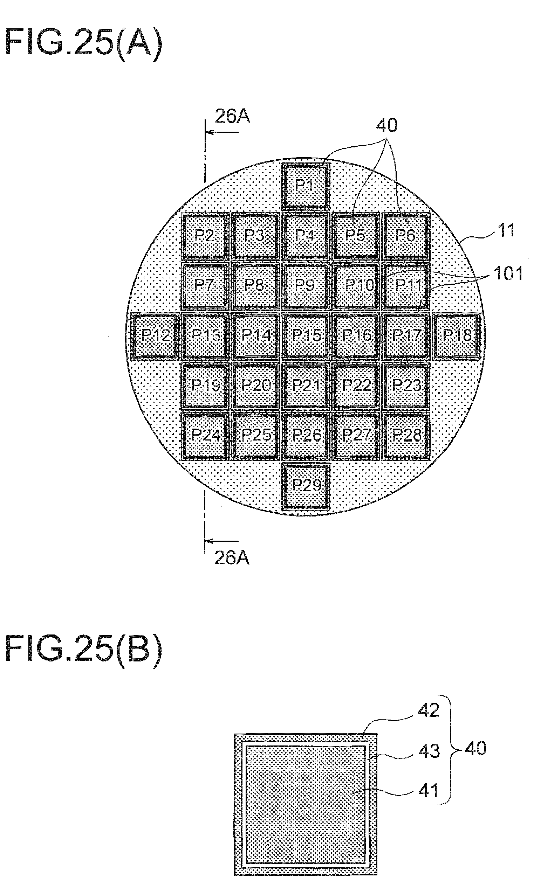

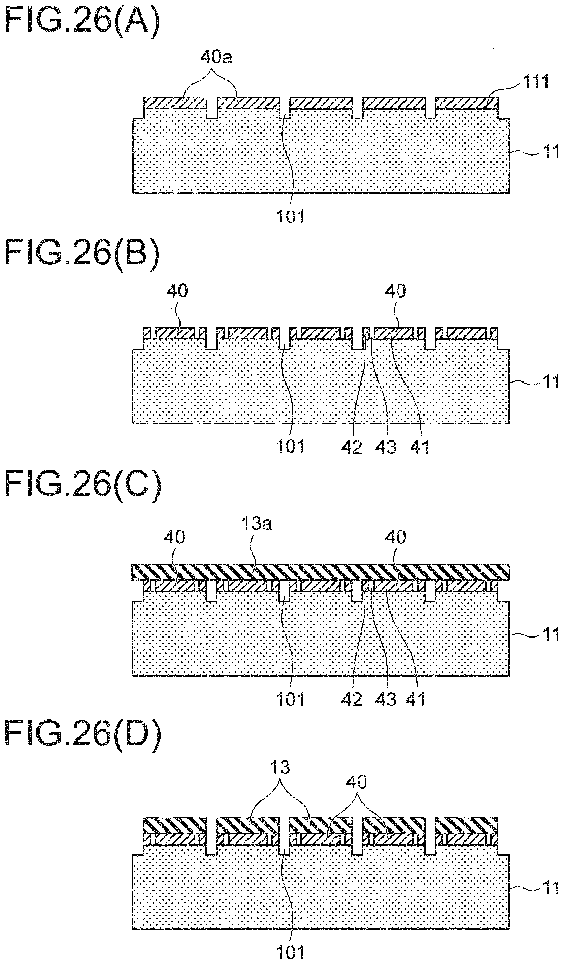

FIG. 24 is a flowchart showing a manufacturing method of a semiconductor element in the fourth embodiment. FIGS. 25(A) and 25(B) are diagrams schematically showing the semiconductor layers 40 separated on the sapphire substrate 11. FIGS. 26(A) to 26(D) are diagrams schematically showing a process of singulating a semiconductor thin-film layer 40a, a process of forming the grooves 43, a process of forming the support layer 13a and a process of singulating the support layer 13a. FIGS. 26(A) to 26(D) correspond to cross-sectional views taken along the line 26A - 26A shown in FIG. 25(A).

As shown in FIG. 25(A), in the fourth embodiment, the semiconductor layers 40 are formed instead of the semiconductor layers 12 (FIG. 3) in the first embodiment. As shown in FIG. 25(B), each semiconductor layer 40 includes the groove 43 extending along the outer periphery of the semiconductor layer 40. In the semiconductor layer 40, a part on the inner side of the groove 43 is referred to as a central part 41, and a frame-like part on the outer side of the groove 43 is referred to as an outer peripheral part 42. The central part 41 is a part that is made into an LED or the like by processing in a later process.

In this example, the semiconductor layer 40 is in a quadrangular shape (for example, square shape), and thus the groove 43 extends along the four sides of the quadrangular shape. However, the groove 43 is not limited to such a shape, but may extend along the circumference of a circle, for example. The semiconductor layer 40 is configured in the same way as the semiconductor layer 12 in the first embodiment except for including the groove 43.

### <Process of Forming Semiconductor Thin-film Layer to Process of Singulating Semiconductor Thin-film Layer>

The process of forming the semiconductor thin-film layer 40a on the sapphire substrate 11 (step S101 in FIG. 24) is as described in the first embodiment. Further, the process of separating (singulating) the semiconductor thin-film layer 40a into a plurality of semiconductor layers 40 as shown in FIG. 26(A) (step S102) is also as described in the first embodiment. The semiconductor layer 40 is referred to also as the semiconductor thin film (or the semiconductor thin film piece).

### <Process of Forming Groove>

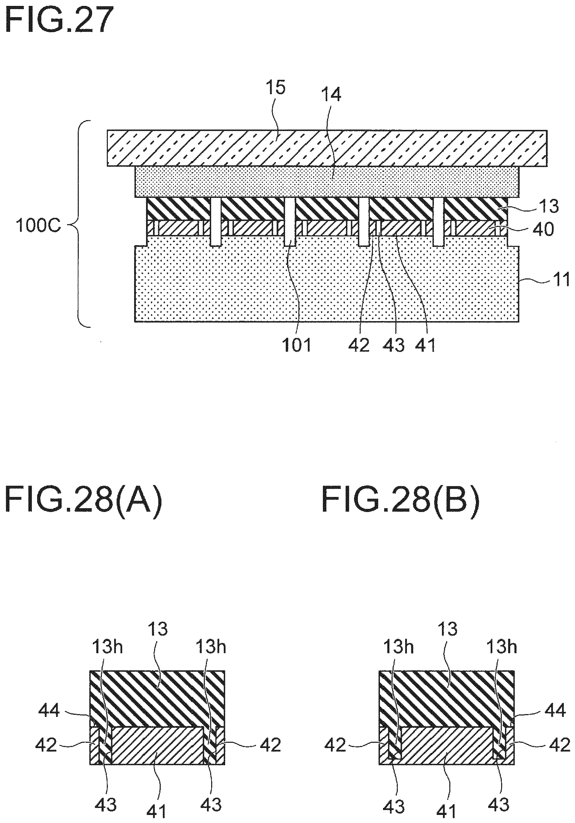

In the subsequent step S401 (FIG. 24), the groove 43 is formed in each semiconductor layer 40 on the sapphire substrate 11 by means of photolithography. The groove 43 may be formed either to penetrate the semiconductor layer 40 in its thickness direction (FIG. 28(A) which will be explained later) or to a depth not to penetrate the semiconductor layer 40 (FIG. 28(B) which will be explained later).

### <Process of Forming Support Layer to Process of Singulating Support Layer>

In the subsequent step S103 (FIG. 24), the support layer 13a is formed to cover the semiconductor layers 40 as shown in FIG. 26(C). Further, in step S104, the support layer 13a is patterned by means of photolithography and thereby separated (singulated) into a plurality of supports 13 similarly to the semiconductor layers 40. These processes are as described in the first embodiment.

By these processes, a plurality of islands (stacked structures) each formed by stacking the semiconductor layer 40 and the support 13 are formed on the sapphire substrate 11 as shown in FIG. 26(D).

### <Process of Joining to Glass Substrate>

In the subsequent step S105 (FIG. 24), the supports 13 on the semiconductor layer 40 are joined to the glass substrate 15 via the adhesive member 14 as described in the first embodiment. The adhesive member 14 is as described in the first embodiment.

By this process, a semiconductor substrate 100C including the sapphire substrate 11, the plurality of islands (stacked structures) each including the semiconductor layer 40 and the support 13, the adhesive member 14 and the glass substrate 15 is formed as shown in FIG. 27.

FIGS. 28(A) and 28(B) are cross-sectional views schematically showing the semiconductor layer 40 and the support 13. A surface of the semiconductor layer 40 on a side opposite to the sapphire substrate 11 (i.e., a surface on which the support 13 is formed) is defined as a formation surface 44.

The groove 43 of the semiconductor layer 40 is formed from the formation surface 44 toward the sapphire substrate 11. The groove 43 may be formed either to penetrate the semiconductor layer 40 in its thickness direction as shown in FIG. 28(A) or to a depth not to penetrate the semiconductor layer 40 as shown in FIG. 28(B).

The support 13 has a lower Young's modulus than the semiconductor layer 40, and thus is softer than the semiconductor layer 40. Therefore, a part (referred to as a "fitting part 13h") of the support 13 fits into the groove 43 of the semiconductor layer 40.

In the example shown in FIG. 28(A), the fitting part 13h of the support 13 is joined to an inner surface of the groove 43. In the example shown in FIG. 28(B), the fitting part 13h of the support 13 is joined to the inner surface and a bottom surface of the groove 43.

In either case, the semiconductor layer 40 and the support 13 can be firmly fixed together since the fitting part 13h of the support 13 is joined to the inner surfaces of the groove 43 of the semiconductor layer 40.

### <Process of Peeling off Semiconductor Layer>

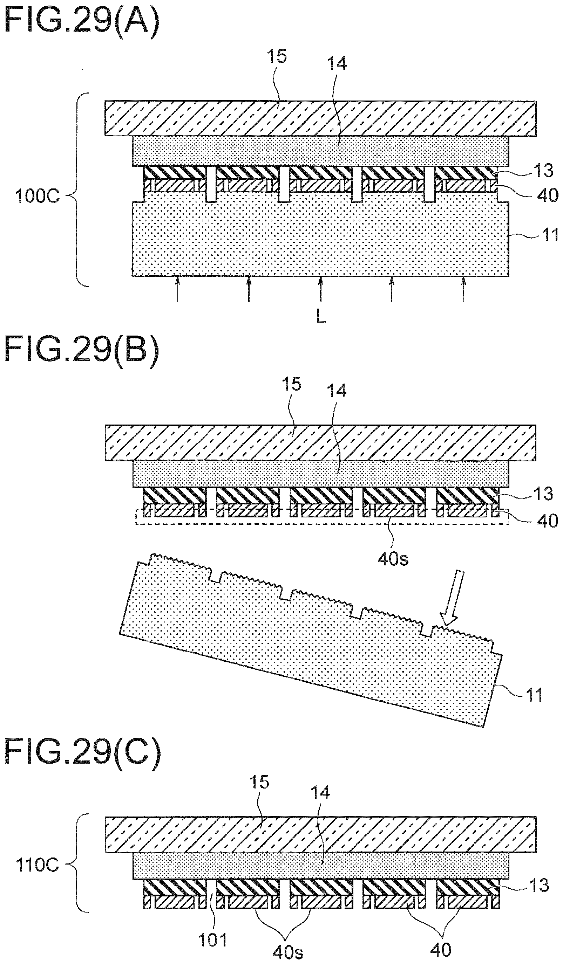

In the subsequent step S106 (FIG. 24), the semiconductor layer 40 is peeled off from the sapphire substrate 11 by applying laser light to the semiconductor layer 40. FIGS. 29(A) to 29(C) are cross-sectional views schematically showing the process of peeling off the semiconductor layer 40 from the sapphire substrate 11.

As shown in FIG. 29(A), the laser light is applied to the semiconductor layer 40 from the sapphire substrate 11 side of the semiconductor substrate 100C. Accordingly, the semiconductor layers 40 peel off from the sapphire substrate 11 as shown in FIG. 29(B) .

By this process, an intermediate structure (pre-polishing structure) 110C including a plurality of islands each including the semiconductor layer 40 and the support 13, the adhesive member 14 and the glass substrate 15 is obtained.

### <Process of Polishing Semiconductor Layer>

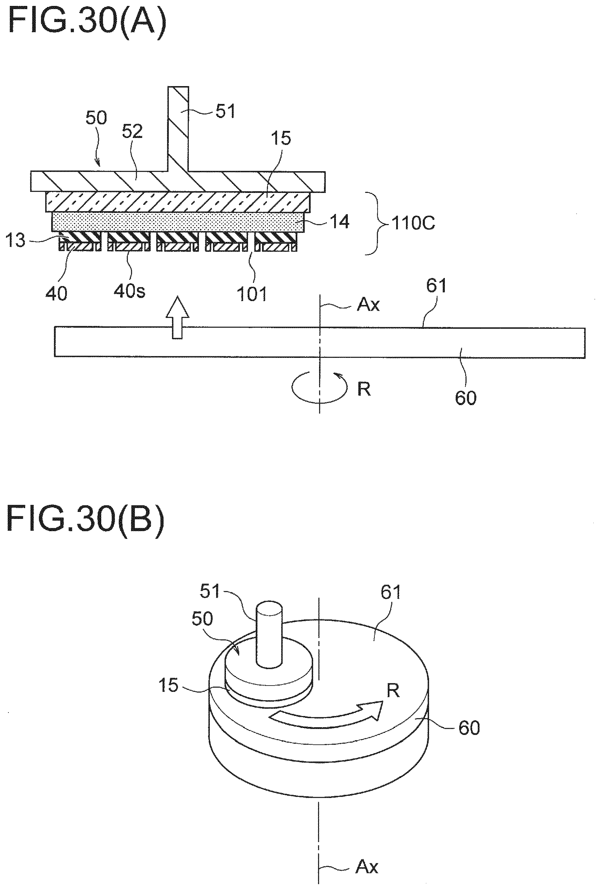

In the subsequent step S107 (FIG. 24), the surfaces 40s of the semiconductor layer 40 are polished. FIGS. 30(A) and 30(B) are a cross-sectional view and a perspective view schematically showing the process of polishing the surfaces 40s of the semiconductor layer 40.

As shown in FIG. 30(A), in the polishing process, the glass substrate 15 of the intermediate structure 110C is fixed to the carrier 50 of the polishing device. The polishing device and the polishing method are as described in the first embodiment.

Further, in the case where the groove 43 of each semiconductor layer 40 has a depth not to penetrate the semiconductor layer 40 (FIG. 28(B)), the amount of the polishing can be checked during the polishing of the semiconductor layer 40 based on whether the groove 43 is exposed or not (i.e., whether the groove 43 penetrates the semiconductor layer 40 or not).

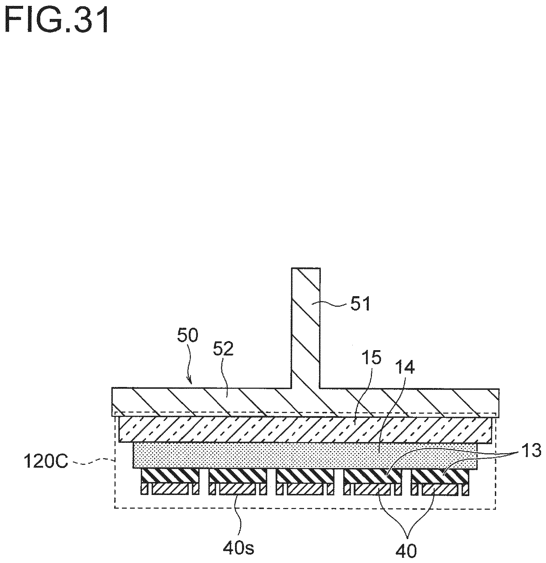

By this process, a semiconductor layer support structure 120C including a plurality of islands each including the semiconductor layer 40 and the support 13, the adhesive member 14 and the glass substrate 15 is obtained as shown in FIG. 31.

Since the semiconductor layer 40 is divided by the groove 43 into the central part 41 and the outer peripheral part 42, the stress at the time of the polishing is likely to concentrate on the outer peripheral part 42. Thus, by removing the outer peripheral part 42 in a later process, the occurrence of the cracking or chipping in the central part 41, which is to be made into an LED or the like, can be inhibited.

### <Process of Joining to Silicon Substrate to Process of Removing Support>

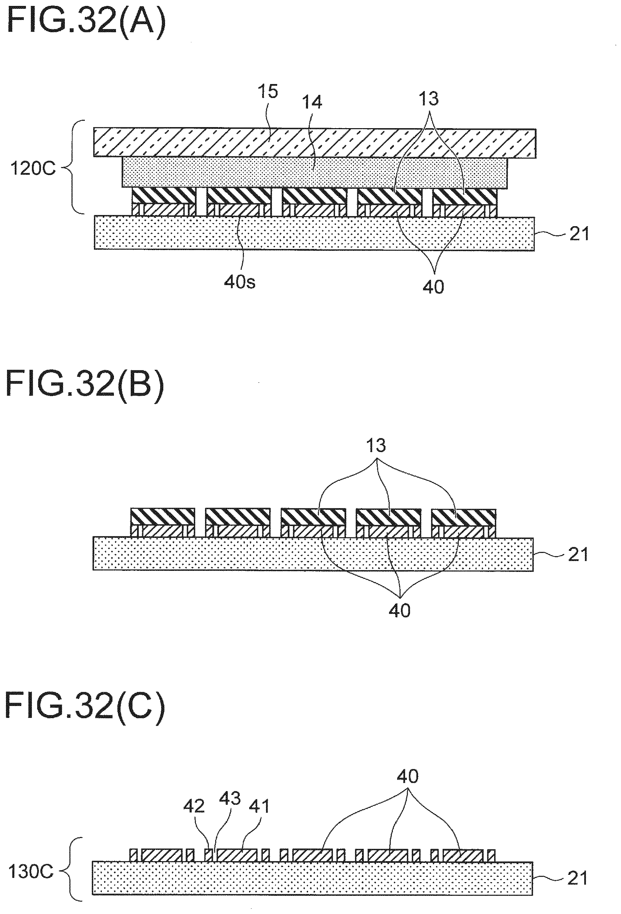

FIGS. 32(A), 32(B) and 32(C) are schematic diagrams showing a process of joining the semiconductor layers 40 to the silicon substrate 21, a process of removing the adhesive member 14 and a process of removing the supports 13.

In step S108 (FIG. 24), the surfaces 40s of the semiconductor layers 40 of the semiconductor layer support structure 120C detached from the carrier 50 are joined to the silicon substrate 21 as the transfer substrate as shown in FIG. 32 (A).

In step S109 (FIG. 24), the adhesive member 14 is removed as shown in FIG. 32 (B). The method of removing the adhesive member 14 is as described in the first embodiment.

By removing the supports 13, a base substrate 130C in which a plurality of semiconductor layers 40 are arrayed in a grid on the silicon substrate 21 is obtained. The semiconductor layer 40 is referred to also as the semiconductor element.

The semiconductor layer 40 of the base substrate 130C is patterned as described in the first embodiment and thereby made into an LED, for example. At this stage, the outer peripheral part 42 of the semiconductor layer 40 is also removed and the central part 41 is made into an LED, for example.

### <Effect of Fourth Embodiment>

As described above, in the fourth embodiment, the semiconductor layer 40 includes the groove 43, and thus the stress at the time of the polishing concentrates on the outer peripheral part 42 of the semiconductor layer 40. Thus, by removing the outer peripheral part 42, the occurrence of the cracking or chipping in the central part 41 to be made into an LED or the like can be prevented.

Incidentally, in the fourth embodiment, it is also possible to employ a support 16 having structure of two or more layers like the support 16 in the second embodiment, or to set the area of the support 13 in the outer circumferential region of the sapphire substrate 11 larger than the area of the support 13 in the central region as in the third embodiment.

The present disclosure is applicable to a manufacturing method of a semiconductor element such as an LED and to a semiconductor layer support structure and a semiconductor substrate used for the manufacture of semiconductor elements.

In the following, various modes according to the present disclosure will be described together as appendixes.

### (Appendix 15)

A semiconductor substrate comprising:
a sapphire substrate;
a plurality of islands formed on the sapphire substrate and each including a semiconductor layer containing a nitride semiconductor and a support formed on the semiconductor layer; and
a retention substrate to which the supports of the plurality of islands are joined by using an adhesive member.

### (Appendix 16)

The semiconductor substrate according to appendix 15, wherein the semiconductor layer has a formation surface, on which the support is formed, on a side opposite to the sapphire substrate,
wherein the formation surface is provided with a groove formed to extend in a first direction and a second direction that are parallel to the formation surface and orthogonal to each other, and
wherein a part of the support fits into the groove and is joined to a bottom part and a side face of the groove.

### (Appendix 17)

The semiconductor substrate according to appendix 15 or 16, wherein the support includes:
a first support formed on the semiconductor layer; and
a second support formed on the first support.

### (Appendix 18)

The semiconductor substrate according to appendix 15 or 16, wherein the adhesive member is softer than the semiconductor layer and the support.

### DESCRIPTION OF REFERENCE CHARACTERS

11: sapphire substrate (growth substrate), 12: semiconductor layer, 12a: semiconductor thin-film layer, 12s: surface, 13: support, 13a: support layer, 13h: fitting part, 14: adhesive member, 15: glass substrate (retention substrate), 16: support, 17: first support, 17a: first support layer, 18: second support, 18a: second support layer, 21: silicon substrate, 40: semiconductor layer, 40a: semiconductor thin-film layer, 40s: surface, 41: center part, 42: outer peripheral part, 43: groove, 50: carrier, 51: support shaft, 52: disk part, 60: polishing plate, 61: polishing pad, 100, 100A, 100C: semiconductor substrate, 101: groove, 110, 110A, 110B, 110C: intermediate structure, 120, 120A, 120C: semiconductor layer support structure, 130, 130A, 130C: base substrate, 140: adhesive layer, 141: base member, 142: first adhesive layer, 143: second adhesive layer.

## Claims

1. A manufacturing method of a semiconductor element, comprising:
a formation process of forming a plurality of islands, each including a semiconductor layer (12, 40) containing a nitride semiconductor and a support (13, 16) formed on the semiconductor layer (12, 40), on a sapphire substrate (11);
a joining process of joining the support (13, 16) to a retention substrate (15) via an adhesive member (14);
a peeling process of peeling off the semiconductor layer (12, 40) from the sapphire substrate (11) by irradiating the semiconductor layer (12, 40) with laser light; and
a polishing process of polishing a surface of the semiconductor layer (12, 40) peeled off from the sapphire substrate (11).

2. The manufacturing method of a semiconductor element according to claim 1, wherein the semiconductor layer (40) has a formation surface (44), on which the support (13) is formed, on a side opposite to the sapphire substrate (11), and
wherein the formation surface (44) is provided with a groove (43) formed to extend in a first direction and a second direction that are parallel to the formation surface (44) and orthogonal to each other, and
wherein a part (13h) of the support (13) fits into the groove (43) and is joined to an inner surface of the groove (43).

3. The manufacturing method of a semiconductor element according to claim 1 or 2, wherein the support (16) includes:
a first support (17) formed on the semiconductor layer (12, 40); and
a second support (18) formed on the first support (17).

4. The manufacturing method of a semiconductor element according to claim 1 or 2, wherein the plurality of islands are formed by:
forming a semiconductor thin-film layer (12a, 40a) containing a nitride semiconductor on the sapphire substrate (11),
separating the semiconductor thin-film layer (12a, 40a) into a plurality of semiconductor layers (12, 40),
forming a support layer (13a) to cover the plurality of semiconductor layers (12, 40), and
separating the support layer (13a) into a plurality of supports (13) corresponding to the semiconductor layers (12, 40).

5. The manufacturing method of a semiconductor element according to claim 4, wherein in the process of separating the support layer (13a) into a plurality of supports (13), the supports (13) are formed so that area of the support (E1-E4) situated in an outer circumferential region of the sapphire substrate (11) is larger than area of the support (E0) situated in a central region of the sapphire substrate (11).

6. The manufacturing method of a semiconductor element according to claim 1 or 2, wherein a Young's modulus of the support (13, 16) is lower than a Young's modulus of the semiconductor layer (12, 40).

7. The manufacturing method of a semiconductor element according to claim 1 or 2, wherein thickness of the support (13, 16) is greater than thickness of the semiconductor layer (12, 40).

8. The manufacturing method of a semiconductor element according to claim 1 or 2, wherein the adhesive member (14) is softer than the semiconductor layer (12, 40) and the support (13, 16) .

9. The manufacturing method of a semiconductor element according to claim 1 or 2, wherein thickness of the adhesive member (14) is greater than a sum of thickness of the semiconductor layer (12, 40) and thickness of the support (13, 16) .

10. The manufacturing method of a semiconductor element according to claim 1 or 2, wherein the adhesive member (14) includes a base member (141), a first adhesive layer (142) provided on a surface of the base member (141) on the support (13) side, and a second adhesive layer (143) provided on a surface on a side opposite to the first adhesive layer (142).

11. A semiconductor layer support structure (120, 120A, 120C) comprising:
a plurality of islands each including a semiconductor layer (12, 40) containing a nitride semiconductor and a support (13, 16) formed on the semiconductor layer (12, 40); and
a retention substrate (15) to which the support (13, 16) s of the plurality of islands are joined by using an adhesive member (14).

12. The semiconductor layer support structure (120, 120A, 120C) according to claim 11, wherein the semiconductor layer (40) has a formation surface (44) on which the support (13) is formed,
wherein the formation surface (44) is provided with a groove (43) formed to extend in a first direction and a second direction that are parallel to the formation surface (44) and orthogonal to each other, and
wherein a part (13h) of the support (13) fits into the groove (43) and is joined to a bottom part and a side face of the groove (43).

13. The semiconductor layer support structure (120, 120A, 120C) according to claim 11 or 12, wherein the support (16) includes:
a first support (17) formed on the semiconductor layer (12); and
a second support (18) formed on the first support (17).

14. The semiconductor layer support structure (120, 120A, 120C) according to claim 11 or 12, wherein the adhesive member (14) is softer than the semiconductor layer (12, 40) and the support (13, 16) .

15. A semiconductor substrate (100, 100A, 100C) comprising:
a sapphire substrate (11);
a plurality of islands formed on the sapphire substrate (11) and each including a semiconductor layer (12, 40) containing a nitride semiconductor and a support (13, 16) formed on the semiconductor layer (12, 40); and
a retention substrate (15) to which the supports (13, 16) of the plurality of islands are joined by using an adhesive member (14).
